# EUROPEAN PATENT APPLICATION

(11) **EP 4 783 796 A1**
(43) Date of publication of application: **29.07.2026**
(21) Application number: 24868152.0
(22) Date of filing: 06.09.2024
(51) Int. Cl.: H10K 30/60, H10D 30/01, H10K 30/30, H10K 39/32, H10K 50/805, H10K 85/60

(54) **PHOTOELECTRIC CONVERSION ELEMENT, IMAGING ELEMENT, OPTICAL SENSOR, METHOD FOR PRODUCING IMAGING ELEMENT, AND COMPOUND**

(30) Priority: 22.09.2023 JP 2023158368; 27.08.2024 JP 2024145785
(71) Applicant: FUJIFILM Corporation, Tokyo 106-8620 (JP)
(72) Inventor: IZUMI, Saika, Ashigarakami-gun, Kanagawa 258-8577 (JP); YAMAMOTO, Yosuke, Ashigarakami-gun, Kanagawa 258-8577 (JP); SUGIURA, Hiroki, Ashigarakami-gun, Kanagawa 258-8577 (JP); YONEKUTA, Yasunori, Ashigarakami-gun, Kanagawa 258-8577 (JP)
(74) Representative: HGF
(86) International application number: PCT/JP2024/032071
(87) International publication number: WO 2025/063074

(57) **Abstract**

The present invention provides a photoelectric conversion element having a small electric field strength dependence of the quantum efficiency for blue-green light. The photoelectric conversion element according to the embodiment of the present invention includes a conductive film, a photoelectric conversion film, and a transparent conductive film in this order, in which the photoelectric conversion film includes a predetermined compound.

## Description

### BACKGROUND OF THE INVENTION

### 1. Field of the Invention

The present invention relates to a photoelectric conversion element, an imaging element, an optical sensor, a method for manufacturing an imaging element, and a compound.

### 2. Description of the Related Art

In recent years, development of an element (for example, an imaging element) having a photoelectric conversion film has progressed.

For example, EP3333170A discloses a compound having a specific structure as a compound that can be applied to an organic semiconductor material such as an organic solar cell.

### SUMMARY OF THE INVENTION

With the demand for improvement in performance of an imaging element, an optical sensor, and the like, there is a demand for a photoelectric conversion element which exhibits excellent characteristics. Examples of the characteristics required for the photoelectric conversion element include that a quantum efficiency of the photoelectric conversion element is not easily changed even in a case where an electric field strength is changed, that is, an electric field strength dependence of the quantum efficiency is small.

Under such a demand, the present inventors have produced and examined a photoelectric conversion element including the compound disclosed in EP3333170A, and found that the electric field strength dependence of the quantum efficiency for blue-green light is high and there is room for improvement. In the present specification, the blue-green light is intended to be light having a wavelength of 400 to 530 nm.

Therefore, an object of the present invention is to provide a photoelectric conversion element having a small electric field strength dependence of the quantum efficiency for blue-green light.

Another object of the present invention is to provide an imaging element, an optical sensor, a method for manufacturing an imaging element, and a compound, which are related to the above-described photoelectric conversion element.

As a result of conducting an extensive investigation to achieve the objects, the present inventors have found that the objects can be achieved by the following constitution.
[1] A photoelectric conversion element including, in the following order: a conductive film; a photoelectric conversion film; and a transparent conductive film, in which the photoelectric conversion film contains a compound represented by Formula (1) described later.
[2] The photoelectric conversion element according to [1], in which in a case where D represents a group represented by Formula (2) described later, at least one of a requirement X1 or a requirement X2 described later is satisfied, and in a case where D represents a group represented by Formula (3) described later, at least one of a requirement Y1 or a requirement Y2 described later is satisfied.
[3] The photoelectric conversion element according to [1] or [2], in which A¹ and A² each independently represent a group represented by Formula (A-1) described later.
[4] The photoelectric conversion element according to any one of [1] to [3], in which X²² represents a sulfur atom, an oxygen atom, or a selenium atom, and X³² represents a sulfur atom, an oxygen atom, or a selenium atom.
[5] The photoelectric conversion element according to any one of [1] to [4], in which X²¹ represents -NR^{X1}-, -CR^{X2}R^{X3}-, or -SiR^{X4}R^{X5}-, and X³¹ represents -NR^{X1}-, -CR^{X2}R^{X3}-, or - SiR^{X4}R^{X5}-.
[6] The photoelectric conversion element according to any one of [1] to [5], in which Y²¹ to Y²⁴ each independently represent -CR^{Y1}=, and Y³¹ to Y³⁴ each independently represent - CR^{Y1}=.
[7] The photoelectric conversion element according to any one of [1] to [6], in which the photoelectric conversion film further contains an n-type organic semiconductor, and the photoelectric conversion film has a bulk heterojunction structure formed in a state in which the compound represented by Formula (1) and the n-type organic semiconductor are mixed with each other.
[8] The photoelectric conversion element according to [7], in which the n-type organic semiconductor contains fullerenes selected from the group consisting of a fullerene and derivatives of the fullerene.
[9] The photoelectric conversion element according to any one of [1] to [8], in which the photoelectric conversion film further contains a p-type organic semiconductor.
[10] The photoelectric conversion element according to any one of [1] to [9], in which the photoelectric conversion film further contains a coloring agent.
[11] The photoelectric conversion element according to any one of [1] to [10], further including one or more interlayers between the conductive film and the transparent conductive film, in addition to the photoelectric conversion film.
[12] An imaging element including the photoelectric conversion element according to any one of [1] to [10].
[13] An optical sensor including the photoelectric conversion element according to any one of [1] to [10].
[14] A method for manufacturing an imaging element, including a step of manufacturing the photoelectric conversion element according to any one of [1] to [10].
[15] A compound represented by Formula (1) described later.
[16] The compound according to [15], in which in a case where D represents a group represented by Formula (2), at least one of a requirement X1 or a requirement X2 described later is satisfied, and in a case where D represents a group represented by Formula (3), at least one of a requirement Y1 or a requirement Y2 described later is satisfied.
[17] The compound according to [15] or [16], in which A¹ and A² each independently represent a group represented by Formula (A-1).
[18] The compound according to any one of [15] to [17], in which X²² represents a sulfur atom, an oxygen atom, or a selenium atom, and X³² represents a sulfur atom, an oxygen atom, or a selenium atom.
[19] The compound according to any one of [15] to [18], in which X²¹ represents - NR^{X1}-, -CR^{X2}R^{X3}-, or -SiR^{X4}R^{X5}-, and X³¹ represents -NR^{X1}-, -CR^{X2}R^{X3}-, or -SiR^{X4}R^{X5}-.
[20] The compound according to any one of [15] to [19], in which Y²¹ to Y²⁴ each independently represent -CR^{Y1}=, and Y³¹ to Y³⁴ each independently represent -CR^{Y1}=.

According to the present invention, a photoelectric conversion element having a small electric field strength dependence of the quantum efficiency for blue-green light can be provided.

In addition, according to the present invention, it is also possible to provide an imaging element, an optical sensor, a method for manufacturing an imaging element, and a compound, which are related to the above-described photoelectric conversion element.

### BRIEF DESCRIPTION OF THE DRAWINGS

FIG. 1 is a schematic cross-sectional view showing an example of a configuration of a photoelectric conversion element.
FIG. 2 is a schematic cross-sectional view showing an example of a configuration of a photoelectric conversion element.

### DESCRIPTION OF THE PREFERRED EMBODIMENTS

Hereinafter, the present invention will be described in detail.

The description of the configuration requirements described below is made on the basis of representative embodiments of the present invention, but it should not be construed that the present invention is limited to those embodiments.

In the present specification, numerical ranges represented by "to" include numerical values before and after "to" as lower limit values and upper limit values.

In the present specification, a hydrogen atom may be any of a light hydrogen atom (normal hydrogen atom) or a heavy hydrogen atom (for example, a deuterium atom or the like).

In the present specification, in a case of a plurality of substituents, linking groups, and the like (hereinafter, also referred to as "substituent and the like") represented by a specific reference numeral, or in a case of simultaneously defining a plurality of the substituent and the like, it means that each of the substituent and the like may be the same as or different from each other. This also applies to a case of specifying the number of substituents and the like.

In the present specification, the "substituent" includes a group exemplified as the following substituent W, unless otherwise specified.

### (Substituent W)

The substituent W in the present specification will be described below.

Examples of the substituent W include a halogen atom (for example, a fluorine atom, a chlorine atom, a bromine atom, an iodine atom, and the like), an alkyl group (including a cycloalkyl group, a bicycloalkyl group, and a tricycloalkyl group), an alkenyl group (including a cycloalkenyl group and a bicycloalkenyl group), an alkynyl group, an aryl group, a heterocyclic group (a heteroaryl group or an aliphatic heterocyclic group), a cyano group, a nitro group, an alkoxy group, an aryloxy group, a silyl group, a silyloxy group, a heterocyclic oxy group, an acyloxy group, a carbamoyloxy group, an alkoxycarbonyloxy group, an aryloxycarbonyloxy group, a primary, secondary, or tertiary amino group (including an anilino group), an alkylthio group, an arylthio group, a heterocyclic thio group, an alkylsulfinyl group or an arylsulfinyl group, an alkyl or an arylsulfonyl group, an acyl group, an aryloxycarbonyl group, an alkoxycarbonyl group, an aryl or a heterocyclic azo group, an imide group, a phosphino group, a phosphinyl group, a phosphinyloxy group, a phosphinylamino group, a phosphono group, a carboxy group, a phosphoric acid group, a sulfonic acid group, a hydroxy group, a thiol group, an acylamino group, a carbamoyl group, a ureido group, and a boronic acid group. Each of the above-described groups may further have a substituent (for example, one or more groups of each of the above-described groups), as possible. For example, an alkyl group which may have a substituent is also included as the form of the substituent W.

In a case where the substituent W has a carbon atom, the number of carbon atoms in the substituent W is, for example, 1 to 20.

The number of atoms other than a hydrogen atom in the substituent W is, for example, 1 to 30.

It is also preferable that a specific compound described later does not contain, as a substituent, a carboxy group, a salt of a carboxy group, a phosphoric acid group, a salt of a phosphoric acid group, a sulfonic acid group, a salt of a sulfonic acid group, a hydroxy group, a thiol group, an acylamino group, a carbamoyl group, a ureido group, or a boronic acid group (-B(OH)₂) and/or a primary amino group.

In the present specification, examples of the halogen atom include a fluorine atom, a chlorine atom, a bromine atom, and an iodine atom.

In the present specification, unless otherwise specified, the aliphatic hydrocarbon group may be linear, branched, or cyclic.

Examples of the above-described aliphatic hydrocarbon group include an alkyl group, an alkenyl group, and an alkynyl group.

In the present specification, unless otherwise specified, the number of carbon atoms of the alkyl group is preferably 1 to 20, more preferably 1 to 10, and still more preferably 1 to 6.

Unless otherwise specified, the alkyl group may be linear, branched, or cyclic.

Examples of the alkyl group include a methyl group, an ethyl group, an n-propyl group, an isopropyl group, an n-butyl group, a sec-butyl group, a tert-butyl group, an n-hexyl group, a cyclopropyl group, and a cyclopentyl group.

The cyclic alkyl group may be any of a cycloalkyl group, a bicycloalkyl group, or a tricycloalkyl group, and the alkyl group may have a ring structure thereof as a partial structure.

In the alkyl group which may have a substituent, examples of the substituent which may be included in the alkyl group include the groups exemplified as the substituent W. Among these, an aryl group (preferably having 6 to 18 carbon atoms and more preferably having 6 carbon atoms), a heteroaryl group (preferably having 5 to 18 carbon atoms and more preferably having 5 or 6 carbon atoms), or a halogen atom (preferably a fluorine atom or a chlorine atom) is preferable.

In the present specification, unless otherwise specified, the alkyl group portion in the alkoxy group and the alkylthio group is preferably the above-described alkyl group.

In the alkoxy group which may have a substituent, examples of the substituent which may be included in the alkoxy group include the same examples as the substituent in the alkyl group which may have a substituent.

In the alkylthio group which may have a substituent, examples of the substituent which may be included in the alkylthio group include the same examples as the substituent in the alkyl group which may have a substituent.

In the present specification, the alkenyl group may be any of linear, branched, or cyclic, unless otherwise specified. The number of carbon atoms in the above-described alkenyl group is preferably 2 to 20. In the alkenyl group which may have a substituent, examples of the substituent which may be included in the alkenyl group include the same examples as the substituent in the alkyl group which may have a substituent.

In the present specification, the alkynyl group may be any of linear, branched, or cyclic, unless otherwise specified. The number of carbon atoms in the above-described alkynyl group is preferably 2 to 20. In the alkynyl group which may have a substituent, examples of the substituent which may be included in the alkynyl group include the same examples as the substituent in the alkyl group which may have a substituent.

In the present specification, unless otherwise specified, an aromatic ring or an aromatic ring constituting the aromatic ring group may be any of a monocyclic ring or a polycyclic ring (for example, 2 to 6 rings or the like).

The monocyclic aromatic ring is an aromatic ring having only one aromatic ring structure as a ring structure. The polycyclic (for example, 2 to 6 rings) aromatic ring has a fused ring structure including a plurality of (for example, 2 to 6) monocyclic aromatic rings. The monocyclic aromatic ring is preferably a 5-membered ring or a 6-membered ring. In addition, the polycyclic aromatic ring is preferably a fused ring structure including a plurality of (for example, 2 to 6) monocyclic aromatic rings selected from a 5-membered ring and a 6-membered ring.

The number of ring member atoms in the aromatic ring is preferably 5 to 15, and more preferably 5 to 6.

In the present specification, the "number of ring member atoms" in a ring (an aromatic ring, an alicyclic ring, and the like) refers to the number of atoms constituting the ring structure, and in a case of a polycyclic ring, refers to the number of atoms constituting the polycyclic ring.

In the present specification, unless otherwise specified, the aromatic ring may be any of an aromatic hydrocarbon ring or an aromatic heterocyclic ring.

In a case where the above-described aromatic ring is an aromatic heterocyclic ring, the number of heteroatoms included as ring member atoms is, for example, 1 to 10. Examples of the above-described heteroatom include a nitrogen atom, a sulfur atom, an oxygen atom, a selenium atom, a tellurium atom, a phosphorus atom, a silicon atom, and a boron atom.

Examples of the above-described aromatic hydrocarbon ring include a benzene ring, a naphthalene ring, an anthracene ring, a phenanthrene ring, and a fluorene ring.

Examples of the above-described aromatic heterocyclic ring include a pyridine ring, a pyrimidine ring, a pyridazine ring, a pyrazine ring, a triazine ring (for example, 1,2,3-triazine ring, 1,2,4-triazine ring, 1,3,5-triazine ring, and the like), a tetrazine ring (for example, 1,2,4,5-tetrazine ring and the like), a quinoxaline ring, a pyrrole ring, a furan ring, a thiophene ring, an imidazole ring, an oxazole ring, a thiazole ring, a benzopyrrole ring, a benzofuran ring, a benzothiophene ring, a benzimidazole ring, a benzoxazole ring, a benzothiazole ring, a naphthopyrrole ring, a naphthofuran ring, a naphthothiophene ring, a naphthimidazole ring, a naphthoxazole ring, a pyrroloimidazole ring (for example, a 5H-pyrrolo[1,2-a]imidazole ring and the like), an imidazooxazole ring (for example, an imidazo[2,1-b]oxazole ring and the like), a thienothiazole ring (for example, a thieno[2,3-d]thiazole ring and the like), a benzothiadiazole ring, a benzodithiophene ring (for example, benzo[1,2-b:4,5-b']dithiophene ring and the like), a thienothiophene ring (for example, thieno[3,2-b]thiophene ring and the like), a thiazolothiazole ring (for example, thiazolo[5,4-d]thiazole ring and the like), a naphthodithiophene ring (for example, a naphtho[2,3-b:6,7-b']dithiophene ring, a naphtho[2,1-b:6,5-b']dithiophene ring, a naphtho[1,2-b:5,6-b']dithiophene ring, a 1,8-dithiadicyclopenta[b,g]naphthalene ring, and the like), a benzothienobenzothiophene ring, a dithieno[3,2-b:2',3'-d]thiophene ring, and a 3,4,7,8-tetrathiadicyclopenta[a,e]pentalene ring.

In the present specification, examples of the "aromatic ring group" include a group obtained by removing one or more (for example, 1 to 5 or the like) hydrogen atoms from the above-described aromatic ring. In the present specification, in a case of an aromatic hydrocarbon group, examples thereof include a group obtained by removing one or more hydrogen atoms (for example, 1 to 5) from the aromatic hydrocarbon ring, and in a case of an aromatic heterocyclic group, examples thereof include a group obtained by removing one or more hydrogen atoms (for example, 1 to 5) from the aromatic heterocyclic ring.

In the present specification, examples of the "aryl group" include a group obtained by removing one hydrogen atom from a ring corresponding to the aromatic hydrocarbon ring among the above-described aromatic rings.

In the present specification, examples of the "heteroaryl group" include a group obtained by removing one hydrogen atom from a ring corresponding to the aromatic heterocyclic ring among the above-described aromatic rings.

In the present specification, examples of the "arylene group" include a group obtained by removing two hydrogen atoms from a ring corresponding to the aromatic hydrocarbon ring among the above-described aromatic rings.

In the present specification, examples of the "heteroarylene group" include a group obtained by removing two hydrogen atoms from a ring corresponding to the aromatic heterocyclic ring among the above-described aromatic rings.

In the aromatic ring group which may have a substituent, the aryl group which may have a substituent, the heteroaryl group which may have a substituent, the arylene group which may have a substituent, and the heteroarylene group which may have a substituent, examples of the type of the substituent which may be included in these groups include the groups exemplified as the substituent W. The number of substituents in a case where these groups have a substituent may be one or more (for example, 1 to 4).

In the present specification, the non-aromatic ring refers to a ring structure which does not correspond to the aromatic ring, and examples thereof include an aliphatic hydrocarbon ring and an aliphatic heterocyclic ring.

Examples of the above-described aliphatic hydrocarbon ring include a cycloalkane, a cycloalkene, and a cycloalkyne.

Examples of the above-described aliphatic heterocyclic ring include, for example, a pyrrolidine ring, an oxolane ring, a thiolane ring, a piperidine ring, a tetrahydropyran ring, a thiacine ring, a piperazine ring, a morpholine ring, a quinocyclidine ring, an azetidine ring, an oxetane ring, an aziridine ring, a dioxane ring, and a γ-butyrolactone ring.

In the present specification, examples of the "aliphatic hydrocarbon ring group" include a group obtained by removing one or more (for example, 1 to 5 or the like) hydrogen atoms from a ring corresponding to the aliphatic hydrocarbon ring.

In the present specification, examples of the "aliphatic heterocyclic group" include a group obtained by removing one or more (for example, 1 to 5 or the like) hydrogen atoms from a ring corresponding to the aliphatic heterocyclic ring.

In the present specification, in a case where a plurality of identical symbols indicating a type or the number of groups are present in the formula, which indicates a chemical structure, contents of these plurality of identical symbols indicating a type or the number of groups are independent of each other, and the contents of the identical symbols may be the same or different from each other, unless otherwise specified.

In the present specification, in a case where a plurality of identical groups (for example, alkyl groups and the like) are present in the formula, which indicates a chemical structure, specific contents between these plurality of identical groups are independent of each other, and the specific contents between the plurality of identical groups may be the same or different from each other, unless otherwise specified.

A bonding direction of a divalent group (for example, -CO-O-) described in the present specification is not limited unless otherwise specified. For example, in a case where Y in a compound represented by a formula "X-Y-Z" is -CO-O-, the compound may be any of "X-O-CO-Z" or "X-CO-O-Z".

In the present specification, regarding a compound which may have a geometric isomer (cis-trans isomer), a general formula or a structural formula representing the compound may be described only in the form of either a cis isomer or a trans isomer for convenience. Even in such a case, unless otherwise specified, the form of the compound is not limited to either the cis isomer or the trans isomer, and the compound may be the cis isomer or the trans isomer.

In the present specification, unless otherwise specified, * in the formula represents a bonding position.

### [Photoelectric conversion element]

The photoelectric conversion element according to an embodiment of the present invention is a photoelectric conversion element including in the following order, a conductive film, a photoelectric conversion film, and a transparent conductive film, in which the above-described photoelectric conversion film contains a compound represented by Formula (1) (hereinafter, referred to as a "specific compound").

The reason why the photoelectric conversion element having the above-described configuration can achieve the object of the present invention is not necessarily clear, but the present inventors speculate as follows.

The mechanism by which the effect is obtained is not limited by the following supposition. In other words, even in a case where an effect is obtained by a mechanism other than the following, it is included in the scope of the present invention.

The specific compound is a so-called ADA-type coloring agent compound having a donor moiety (D) and an acceptor moiety (A). Since the specific compound has a predetermined donor structure and acceptor structure, excessive aggregation of the specific compounds and trapping of the carrier by a local dipole are suppressed in the photoelectric conversion film. As a result, it is considered that efficient charge separation can be achieved even in a case where the electric field strength is small, and the carrier can be efficiently moved, that is, the electric field strength dependence of the quantum efficiency is small.

Hereinafter, a case where the electric field strength dependence of the quantum efficiency is smaller is referred to as a case where the effect of the present invention is more excellent.

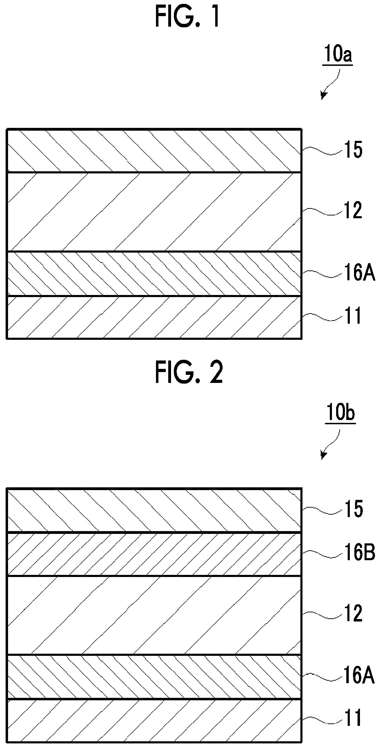

FIG. 1 shows a schematic cross-sectional view of one embodiment of the photoelectric conversion element according to the embodiment of the present invention.

A photoelectric conversion element 10a shown in FIG. 1 has a configuration in which a conductive film (hereinafter, also referred to as "lower electrode") 11 functioning as a lower electrode, an electron blocking film 16A, a photoelectric conversion film 12 containing the specific compound, and a transparent conductive film (hereinafter, also referred to as "upper electrode") 15 functioning as an upper electrode are laminated in this order.

FIG. 2 shows a configuration example of another photoelectric conversion element. A photoelectric conversion element 10b shown in FIG. 2 has a configuration in which the electron blocking film 16A, the photoelectric conversion film 12, a hole blocking film 16B, and the upper electrode 15 are laminated on the lower electrode 11 in this order. The lamination order of the electron blocking film 16A, the photoelectric conversion film 12, and the hole blocking film 16B in FIGS. 1 and 2 may be appropriately changed according to the application and the characteristics.

In the photoelectric conversion element 10a (or 10b), it is preferable that light is incident on the photoelectric conversion film 12 through the upper electrode 15.

In a case where the photoelectric conversion element 10a (or 10b) is used, a voltage can be applied. In this case, it is preferable that the lower electrode 11 and the upper electrode 15 form a pair of electrodes, and a voltage of 1 × 10⁻⁵ to 1 × 10⁷ V/cm is applied between the pair of electrodes. From the viewpoint of performance and power consumption, the applied voltage is more preferably 1 × 10⁻⁴ to 1 × 10⁷ V/cm and still more preferably 1 × 10⁻³ to 5 × 10⁶ V/cm.

Regarding the voltage application method, in FIGS. 1 and 2, it is preferable that the voltage is applied such that the electron blocking film 16A side is a cathode and the photoelectric conversion film 12 side is an anode. In a case where the photoelectric conversion element 10a (or 10b) is used as an optical sensor, or also in a case of being incorporated in an imaging element, the voltage can be applied by the same method.

As described in detail below, the photoelectric conversion element 10a (or 10b) can be suitably applied to applications of an imaging element.

Hereinafter, the form of each layer constituting the photoelectric conversion element according to the embodiment of the present invention will be described in detail.

### [Photoelectric conversion film]

The photoelectric conversion element has a photoelectric conversion film.

### <Specific compound>

The photoelectric conversion film contains the specific compound which is a compound represented by Formula (1).

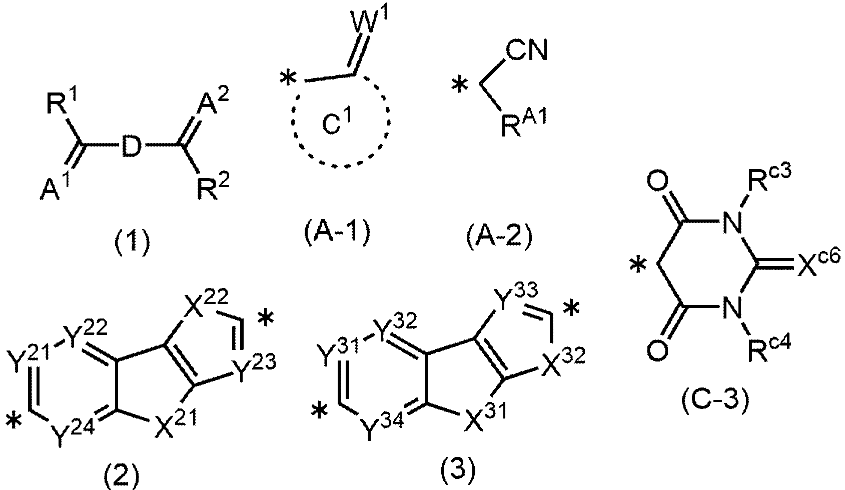

In Formula (1), R¹ and R² each independently represent a hydrogen atom or a substituent.

A¹ and A² each independently represent a group represented by Formula (A-1) or a group represented by Formula (A-2).

D represents a group represented by Formula (2) or a group represented by Formula (3).

In Formula (2), * represents a bonding position.

X²¹ and X²² each independently represent a sulfur atom, an oxygen atom, a selenium atom, -NR^{X1}-, -CR^{X2}R^{X3}-, or -SiR^{X4}R^{X5}-.

Y²¹ to Y²⁴ each independently represent -CR^{Y1}= or a nitrogen atom.

In Formula (3), * represents a bonding position.

X³¹ and X³² each independently represent a sulfur atom, an oxygen atom, a selenium atom, -NR^{X1}-, -CR^{X2}R^{X3}-, or -SiR^{X4}R^{X5}-.

Y³¹ to Y³⁴ each independently represent -CR^{Y1}= or a nitrogen atom.

R^{X1} to R^{X5} each independently represent a hydrogen atom, an aliphatic hydrocarbon group which may have a substituent, an aromatic ring group which may have a substituent, or an aliphatic heterocyclic group which may have a substituent. R^{X2} and R^{X3} may be linked to each other to form a ring, and R^{X4} and R^{X5} may be linked to each other to form a ring.

R^{Y1}'s each independently represent a hydrogen atom or a substituent.

In Formula (A-1), * represents a bonding position.

C¹ represents a ring which contains 2 or more carbon atoms and may have a substituent.

W¹ represents a sulfur atom, an oxygen atom, =NR^{W2}, or =CR^{W3}R^{W4}.

R^{W2} represents a hydrogen atom or a substituent. R^{W3} and R^{W4} each independently represent a cyano group, -SO₂R^{W5}, -COOR^{W6}, or -COR^{W7}. R^{W5} to R^{W7} each independently represent an aliphatic hydrocarbon group which may have a substituent, an aromatic ring group which may have a substituent, or an aliphatic heterocyclic group which may have a substituent.

In Formula (A-2), * represents a bonding position.

R^{A1} represents a cyano group or -COR^{A2}. R^{A2} represents an aromatic ring group which may have a substituent or an aliphatic hydrocarbon group which may have a substituent.

However, in a case where D represents a group represented by Formula (2), X²¹ is - CR^{X2}R^{X3}-, X²² is a sulfur atom, and Y²¹ to Y²⁴ are all -CH=, A¹ and A² each independently represent a group represented by Formula (C-3).

In Formula (C-3), X^{c6} represents an oxygen atom or a sulfur atom.

R^{c3} and R^{c4} each independently represent an aliphatic hydrocarbon group which may have a substituent.

In Formula (2), X²¹ and X²² each independently represent a sulfur atom, an oxygen atom, a selenium atom, -NR^{X1}-, -CR^{X2}R^{X3}-, or -SiR^{X4}R^{X5}-.

From the viewpoint that the effect of the present invention is more excellent, it is preferable that X²¹ represents -NR^{X1}-, -CR^{X2}R^{X3}-, or -SiR^{X4}R^{X5}-.

From the viewpoint that the effect of the present invention is more excellent, it is preferable that X²² represents a sulfur atom, an oxygen atom, a selenium atom, or -NR^{X1}-, and it is more preferable that X²² represents a sulfur atom, an oxygen atom, or a selenium atom.

In addition, it is also preferable that at least one of X²¹ or X²² represents a sulfur atom, an oxygen atom, a selenium atom, -CR^{X2}R^{X3}-, or -SiR^{X4}R^{X5}-.

In Formula (3), X³¹ and X³² each independently represent a sulfur atom, an oxygen atom, a selenium atom, -NR^{X1}-, -CR^{X2}R^{X3}-, or -SiR^{X4}R^{X5}-.

From the viewpoint that the effect of the present invention is more excellent, it is preferable that X³¹ represents -NR^{X1}-, -CR^{X2}R^{X3}-, or -SiR^{X4}R^{X5}-.

From the viewpoint that the effect of the present invention is more excellent, it is preferable that X³² represents a sulfur atom, an oxygen atom, a selenium atom, or -NR^{X1}-, and it is more preferable that X³² represents a sulfur atom, an oxygen atom, or a selenium atom.

In addition, it is also preferable that at least one of X³¹ or X³² represents a sulfur atom, an oxygen atom, a selenium atom, -CR^{X2}R^{X3}-, or -SiR^{X4}R^{X5}-.

R^{X1} to R^{X5} each independently represent a hydrogen atom, an aliphatic hydrocarbon group which may have a substituent, an aromatic ring group which may have a substituent, or an aliphatic heterocyclic group which may have a substituent.

From the viewpoint that the effect of the present invention is more excellent, R^{X1} to R^{X5} are preferably an aliphatic hydrocarbon group which may have a substituent or an aromatic ring group which may have a substituent.

Examples of the substituent which may be included in the aliphatic hydrocarbon group and the aromatic ring group include the substituents exemplified by the substituent W described above, and a substituent selected from a substituent group S described later is preferable.

The aliphatic hydrocarbon group may be linear, branched, or cyclic.

Examples of the above-described aliphatic hydrocarbon group include an alkyl group, an alkenyl group, and an alkynyl group; and an alkyl group is preferable.

The number of carbon atoms in the linear aliphatic hydrocarbon group is preferably 1 to 20, more preferably 1 to 10, still more preferably 1 to 4, and particularly preferably 1 or 2.

The number of carbon atoms in the branched aliphatic hydrocarbon group is preferably 3 to 20, more preferably 3 to 10, still more preferably 3 to 7, and particularly preferably 3 to 5. The cyclic aliphatic hydrocarbon group may be monocyclic or polycyclic.

The number of carbon atoms of the cyclic aliphatic hydrocarbon group is preferably 3 to 20, more preferably 3 to 10, and still more preferably 3 to 6.

The aromatic ring group may be any one of an aromatic hydrocarbon group or an aromatic heterocyclic group.

The above-described aromatic ring group may be a monocyclic ring or a polycyclic ring, but is preferably a monocyclic ring.

The number of ring members in the above-described aromatic ring group is preferably 5 to 18, more preferably 5 to 10, and still more preferably 5 to 8.

The definition and specific examples of the aromatic hydrocarbon group are as described above, and a phenyl group or a naphthyl group is preferable, and a phenyl group is more preferable.

Examples of a heteroatom which is included in the above-described aromatic heterocyclic group include a sulfur atom, an oxygen atom, a nitrogen atom, a selenium atom, a tellurium atom, a phosphorus atom, a silicon atom, and a boron atom; and a sulfur atom, an oxygen atom, or a nitrogen atom is preferable.

The definition and specific examples of the aromatic heterocyclic group are as described above, and a thiophene ring group, a furan ring group, or a pyridine ring group is preferable.

As described above, the aromatic ring group may have a substituent. In a case where the aromatic ring group has a substituent, the number of the substituents is not particularly limited, but is preferably 1 to 3.

The definition of the above-described aliphatic heterocyclic group is as described above.

The number of ring members in the aliphatic heterocyclic group in the aliphatic heterocyclic group which may have a substituent is preferably 5 to 20, more preferably 5 to 12, and still more preferably 5 to 8. The number of carbon atoms in the aliphatic heterocyclic group is preferably 1 to 20.

Examples of a heteroatom which is included in the aliphatic heterocyclic group include a sulfur atom, an oxygen atom, a nitrogen atom, a selenium atom, a tellurium atom, a phosphorus atom, a silicon atom, and a boron atom; and a sulfur atom, an oxygen atom, or a nitrogen atom is preferable.

R^{X2} and R^{X3} may be linked to each other to form a ring, and R^{X4} and R^{X5} may be linked to each other to form a ring.

The above-described ring may be an aromatic ring or a non-aromatic ring, and may be a monocyclic ring or a polycyclic ring.

The above-described ring may have a heteroatom. Examples of the heteroatom include a nitrogen atom, a sulfur atom, an oxygen atom, a selenium atom, a tellurium atom, a phosphorus atom, a silicon atom, and a boron atom; and a sulfur atom, a nitrogen atom, or an oxygen atom is preferable.

The number of ring member atoms in the above-described ring is preferably 3 to 20, more preferably 5 to 12, and still more preferably 5 to 8.

Examples of the substituent which may be contained in the above-described ring include the substituents exemplified as the substituent W described above; and a substituent selected from the substituent group S described later is preferable.

In Formula (2), Y²¹ to Y²⁴ each independently represent -CR^{Y1}= or a nitrogen atom.

From the viewpoint that the effect of the present invention is more excellent, it is preferable that three or more of Y²¹ to Y²⁴ represent -CR^{Y1}=, and it is more preferable that Y²¹ to Y²⁴ represent -CR^{Y1}=.

In addition, in Formula (3), Y³¹ to Y³⁴ each independently represent -CR^{Y1}= or a nitrogen atom.

From the viewpoint that the effect of the present invention is more excellent, it is preferable that three or more of Y³¹ to Y³⁴ represent -CR^{Y1}=, and it is more preferable that Y³¹ to Y³⁴ represent -CR^{Y1}=.

R^{Y1}'s each independently represent a hydrogen atom or a substituent.

Examples of the substituent include the substituents exemplified by the substituent W described above, and an aliphatic hydrocarbon group which may have a substituent, an aromatic ring group which may have a substituent, an aliphatic heterocyclic group which may have a substituent, an alkoxy group which may have a substituent, an aryloxy group which may have a substituent, an amino group which may have a substituent, a cyano group, or a halogen atom is preferable, and an aliphatic hydrocarbon group which may have a substituent, an aromatic ring group which may have a substituent, or a fluorine atom is more preferable.

Examples of the substituent which may be contained in each of the above-described groups which may have a substituent include the substituents exemplified as the substituent W described above; and a substituent selected from a substituent group S described later is preferable.

The definition and suitable aspect of the aliphatic hydrocarbon group which may have a substituent and the aromatic ring group which may have a substituent, represented by R^{Y1}, are the same as those of the aliphatic hydrocarbon group which may have a substituent and the aromatic ring group which may have a substituent, represented by R^{X1} to R^{X5}

An alkyl group in the above-described alkoxy group may be linear, branched, or cyclic.

The number of carbon atoms in the above-described alkoxy group is preferably 1 to 20, more preferably 1 to 10, still more preferably 1 to 5, and particularly preferably 1 to 3.

Examples of the above-described alkoxy group include a methoxy group, an ethoxy group, an n-propoxy group, an n-butoxy group, a tert-butoxy group, and a cyclopropoxy group.

An aryl group in the above-described aryloxy group may be a monocyclic ring or a polycyclic ring.

The number of carbon atoms in the above-described aryloxy group is preferably 5 to 18, more preferably 6 to 10, and still more preferably 6 to 8.

Examples of the above-described aryloxy group include a phenoxy group.

The amino group may be any of a primary amino group, a secondary amino group, or a tertiary amino group, and it is preferably a tertiary amino group.

In the secondary amino group and the tertiary amino group, the substituent substituted on the nitrogen atom is preferably a hydrocarbon group, and it is more preferably an alkyl group (preferably having 1 to 5 carbon atoms) or an aryl group (preferably a phenyl group).

Examples of the above-described halogen atom include a fluorine atom, a chlorine atom, a bromine atom, and an iodine atom; and a fluorine atom or a chlorine atom is preferable.

From the viewpoint that the aggregation of the specific compound can be further suppressed and the effect of the present invention is more excellent, in a case where D represents a group represented by Formula (2), the specific compound satisfies at least one of a requirement X1 or a requirement X2, in a case where D represents a group represented by Formula (3), it is preferable to satisfy at least one of a requirement Y1 or a requirement Y2.

Requirement X1: at least one of X²¹ or X²² represents -NRs-, -CRsR^{X3}-, or -SiRsR^{X5}-.

Requirement X2: at least one of Y²¹ to Y²⁴ represents -CRt=.

Requirement Y1: at least one of X³¹ or X³² represents -NRs-, -CRsR^{X3}-, or -SiRsR^{X5}-.

Requirement Y2: at least one of Y³¹ to Y³⁴ represents -CRt=.

Rs represents an aliphatic hydrocarbon group which may have a substituent, an aromatic ring group which may have a substituent, or an aliphatic heterocyclic group which may have a substituent. Rs and R^{X3} may be linked to each other to form a ring, and Rs and R^{X5} may be linked to each other to form a ring.

Rt represents a substituent.

The definition and suitable aspect of the aliphatic hydrocarbon group which may have a substituent, the aromatic ring group which may have a substituent, or the aliphatic heterocyclic group which may have a substituent, represented by Rs, are the same as those of the aliphatic hydrocarbon group which may have a substituent, the aromatic ring group which may have a substituent, or the aliphatic heterocyclic group which may have a substituent, represented by R^{X1} to R^{X5}.

The definition and suitable aspect of the ring which may be formed by linking Rs and R^{X3} and the ring which may be formed by linking Rs and R^{X5} are the same as those of the ring which may be formed by linking R^{X2} and R^{X3} and the ring which may be formed by linking R^{X4} and R^{X5}.

The definition and suitable aspect of the substituent represented by Rt are the same as those of the substituent represented by R^{Y1}.

The substituent group S will be described in detail.

Substituent group S: linear aliphatic hydrocarbon group having 1 to 3 carbon atoms, branched aliphatic hydrocarbon group having 3 to 7 carbon atoms, cyclic aliphatic hydrocarbon group having 3 to 6 carbon atoms, aromatic ring group having 3 to 20 ring members which may have a substituent, and halogen atom.

The number of carbon atoms in the linear aliphatic hydrocarbon group in the substituent group S is 1 to 3, and it is preferably 1 or 2.

The number of carbon atoms in the branched aliphatic hydrocarbon group in the substituent group S is 3 to 7, and it is preferably 3 or 4.

The cyclic aliphatic hydrocarbon group in the above-described substituent group S is preferably a monocyclic ring.

The above-described aromatic ring group in the above-described substituent group S may be a monocyclic ring or a polycyclic ring, and a monocyclic ring is preferable.

The above-described aromatic ring group may be an aromatic hydrocarbon group or an aromatic heterocyclic group, and an aromatic hydrocarbon group is preferable. The heteroatom included in the aromatic heterocyclic group is preferably an oxygen atom, a nitrogen atom, or a sulfur atom.

The number of ring members in the aromatic ring group is 3 to 20, and it is preferably 5 to 12 and more preferably 5 or 6.

Examples of the substituent which may be contained in the above-described aromatic ring group include the substituents exemplified as the substituent W described above; and a substituent selected from the substituent group S is preferable, and a linear aliphatic hydrocarbon group having 1 to 3 carbon atoms, a branched aliphatic hydrocarbon group having 3 to 7 carbon atoms, or a halogen atom is more preferable.

In a case where the above-described aromatic ring group has a substituent, the number of substituents is preferably 1 to 3.

Examples of the halogen atom in the above-described substituent group S include a fluorine atom, a chlorine atom, a bromine atom, and an iodine atom; and a fluorine atom or a chlorine atom is preferable.

R¹ and R² each independently represent a hydrogen atom or a substituent.

From the viewpoint that the effect of the present invention is more excellent, R¹ and R² are preferably hydrogen atoms.

A¹ and A² each independently represent a group represented by Formula (A-1) or a group represented by Formula (A-2).

However, in a case where D represents a group represented by Formula (2), X²¹ is - CR^{X2}R^{X3}-, X²² is a sulfur atom, and Y²¹ to Y²⁴ are all -CH=, A¹ and A² each independently represent a group represented by Formula (C-3) described later.

From the viewpoint that the effect of the present invention is more excellent, A¹ and A² are each independently preferably a group represented by Formula (A-1), and more preferably a group represented by Formula (C-3).

A¹ and A² may be the same or different from each other, but it is also preferable that A¹ and A² are the same as each other.

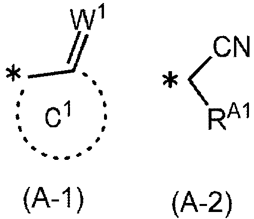

In Formula (A-1), * represents a bonding position.

In Formula (A-1), C¹ represents a ring which contains two or more carbon atoms and may have a substituent. Two carbon atoms contained in C¹ are the two carbon atoms specified in Formula (A-1).

The number of carbon atoms in the above-described ring is preferably 3 to 30, more preferably 3 to 20, and still more preferably 3 to 10. The number of carbon atoms in the above-described ring is the number including the two carbon atoms specified in the formula.

The above-described ring may be an aromatic ring or a non-aromatic ring.

The above-described ring may be any of a monocyclic ring or a polycyclic ring, and is preferably a 5-membered ring, a 6-membered ring, or a fused ring including at least one of a 5-membered ring or a 6-membered ring. The number of carbon atoms in the above-described fused ring including at least one of a 5-membered ring or a 6-membered ring is preferably 6 to 20, more preferably 6 to 15, and still more preferably 8 to 10.

The above-described ring may have a heteroatom. Examples of the heteroatom include a nitrogen atom, a sulfur atom, an oxygen atom, a selenium atom, a tellurium atom, a phosphorus atom, a silicon atom, and a boron atom; and a sulfur atom, a nitrogen atom, or an oxygen atom is preferable.

The number of heteroatoms in the above-described ring is preferably 0 to 10 and more preferably 0 to 5.

Among the carbon atoms constituting the ring represented by C¹, a carbon atom other than the carbon atom at a bonding position to which * is attached in Formula (A-1) and the carbon atom bonded to W¹ may be replaced with a carbonyl carbon (>C=O) or a thiocarbonyl carbon (>C=S).

Examples of the substituent which may be contained in the ring represented by C¹ described above include the groups exemplified as the substituent W; and a halogen atom, an alkyl group, an aromatic ring group, a cyano group, or a silyl group is preferable, and a halogen atom or an alkyl group is more preferable.

The above-described alkyl group may be linear, branched, or cyclic, and is preferably linear.

The number of carbon atoms in the above-described alkyl group is preferably 1 to 10 and more preferably 1 to 3.

As the above-described ring represented by C¹, a ring used as an acidic nucleus (for example, an acidic nucleus of a merocyanine coloring agent) is preferable; and examples thereof include the following nuclei.
(a) 1,3-dicarbonyl nucleus: for example, 1,3-indandione nucleus, 1,3-cyclohexanedione, 5,5-dimethyl-1,3-cyclohexanedione, 1,3-dioxane-4,6-dione, and the like.
(b) pyrazolinone nucleus: for example, 1-phenyl-2-pyrazolin-5-one, 3-methyl-1-phenyl-2-pyrazolin-5-one, 1-(2-benzothiazolyl)-3-methyl-2-pyrazolin-5-one, and the like.
(c) isoxazolinone nucleus: for example, 3-phenyl-2-isoxazolin-5-one, 3-methyl-2-isoxazolin-5-one, and the like.
(d) oxindole nucleus: for example, 1-alkyl-2,3-dihydro-2-oxindole and the like.
(e) 2,4,6-trioxohexahydropyrimidine nucleus: for example, barbituric acid, 2-thibarbituric acid and derivatives thereof, and the like. Examples of the above-described derivatives include a 1-alkyl form such as 1-methyl and 1-ethyl, a 1,3-dialkyl form such as 1,3-dimethyl, 1,3-diethyl, and 1,3-dibutyl, a 1,3-diaryl form such as 1,3-diphenyl, 1,3-di(p-chlorophenyl), 1,3-di(p-ethoxycarbonylphenyl), a 1-alkyl-1-aryl form such as 1-ethyl-3-phenyl, and a 1,3-diheteroaryl form such as 1,3-di(2-pyridyl).
(f) 2-thio-2,4-thiazolidinedione nucleus: for example, rhodanine and derivatives thereof, and the like. Examples of the above-described derivatives include a 3-alkylrhodanine such as 3-methylrhodanine, 3-ethylrhodanine, and 3-allylrhodanine, a 3-arylrhodanine such as 3-phenylrhodanine, and a 3-heteroaryl rhodanine such as 3-(2-pyridyl)rhodanine.
(g) 2-thio-2,4-oxazolidinedione (2-thio-2,4-(3H,5H)-oxazoledione) nucleus: for example, 3-ethyl-2-thio-2,4-oxazolidinedione and the like.
(h) thianaphthenone nucleus: for example, 3(2H)-thianaphthenone-1,1-dioxide and the like.
(i) 2-thio-2,5-thiazolidinedione nucleus: for example, 3-ethyl-2-thio-2,5-thiazolidinedione and the like.
(j) 2,4-thiazolidinedione nucleus: for example, 2,4-thiazolidinedione, 3-ethyl-2,4-thiazolidinedione, 3-phenyl-2,4-thiazolidinedione, and the like.
(k) thiazolin-4-one nucleus: for example, 4-thiazolinone, 2-ethyl-4-thiazolinone, and the like.
(l) 2,4-imidazolidinedione (hydantoin) nucleus: for example, 2,4-imidazolidinedione, 3-ethyl-2,4-imidazolidinedione, and the like.
(m) 2-thio-2,4-imidazolidinedione (2-thiohydantoine) nucleus: for example, 2-thio-2,4-imidazolidinedione, 3-ethyl-2-thio-2,4-imidazolidinedione, and the like.
(n) imidazolin-5-one nucleus: for example, 2-propylmercapto-2-imidazolin-5-one and the like.
(o) 3,5-pyrazolidinedione nucleus: for example, 1,2-diphenyl-3,5-pyrazolidinedione, 1,2-dimethyl-3,5-pyrazolidinedione, and the like.
(p) benzothiophen-3(2H)-one nucleus: for example, benzothiophen-3(2H)-one, oxobenzothiophen-3(2H)-one, dioxobenzothiophen-3(2H)-one, and the like.
(q) indanone nucleus: for example, 1-indanone, 3-phenyl-1-indanone, 3-methyl-1-indanone, 3,3-diphenyl-1-indanone, 3,3-dimethyl-1-indanone, and the like.
(r) benzofuran-3-(2H)-one nucleus: for example, benzofuran-3-(2H)-one and the like. (s) 2,2-dihydrophenalene-1,3-dione nucleus and the like.

In Formula (A-1), W¹ represents an oxygen atom, a sulfur atom, =NR^{W2}, or =CR^{W3}R^{W4}.

From the viewpoint that the effect of the present invention is more excellent, W¹ is preferably an oxygen atom or a sulfur atom, and more preferably an oxygen atom.

R^{W2} represents a hydrogen atom or a substituent. Examples of the substituent include the groups exemplified as the substituent W.

R^{W3} and R^{W4} each independently represent a cyano group, -SO₂R^{W5}, -COOR^{W6}, or - COR^{W7}.

R^{W5} to R^{W7} each independently represent an aliphatic hydrocarbon group which may have a substituent, an aromatic ring group which may have a substituent, or an aliphatic heterocyclic group which may have a substituent.

The definition of the aliphatic hydrocarbon group is as described above, and an aliphatic hydrocarbon group having 1 to 3 carbon atoms is preferable.

The definition of the aromatic ring group is as described above, and an aromatic hydrocarbon group is preferable and a phenyl group is more preferable.

The definition of the aliphatic heterocyclic group is as described above, and a heteroatom contained in the aliphatic heterocyclic group is preferably a sulfur atom, an oxygen atom, or a nitrogen atom.

Examples of the substituent which may be contained in each group represented by R^{W5} to R^{W7} include the substituents exemplified as the substituent W described above.

From the viewpoint that the effect of the present invention is more excellent, the above-described group represented by Formula (A-1) is preferably a group represented by Formula (A-3).

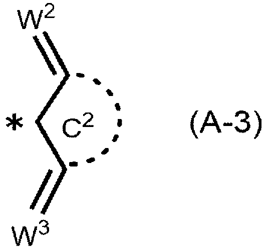

In Formula (A-3), * represents a bonding position.

In Formula (A-3), C² represents a ring which contains at least three carbon atoms and may have a substituent.

Three carbon atoms contained in C² are the three carbon atoms specified in Formula (A-3).

The number of carbon atoms in the above-described ring is preferably 3 to 30, more preferably 3 to 20, and still more preferably 3 to 10. The number of carbon atoms in the above-described ring is the number including the three carbon atoms specified in the formula.

The above-described ring may be an aromatic ring or a non-aromatic ring.

The above-described ring may be any of a monocyclic ring or a polycyclic ring, and is preferably a 5-membered ring, a 6-membered ring, or a fused ring including at least one of a 5-membered ring or a 6-membered ring. The number of carbon atoms in the above-described fused ring including at least one of a 5-membered ring or a 6-membered ring is preferably 6 to 20, more preferably 6 to 15, and still more preferably 8 to 10.

The above-described ring may have a heteroatom. Examples of the heteroatom include a nitrogen atom, a sulfur atom, an oxygen atom, a selenium atom, a tellurium atom, a phosphorus atom, a silicon atom, and a boron atom; and a sulfur atom, a nitrogen atom, or an oxygen atom is preferable.

The number of heteroatoms in the above-described ring is preferably 0 to 10 and more preferably 0 to 5.

Among the carbon atoms constituting the ring represented by C², a carbon atom other than the carbon atom at a bonding position to which * is attached in Formula (A-3) and the carbon atom bonded to Y² or Y³ may be replaced with a carbonyl carbon (>C=O) or a thiocarbonyl carbon (>C=S).

A suitable aspect of the substituent which may be included in the ring is the same as that of the substituent which may be included in the ring C¹ described above.

In Formula (A-3), W² and W³ each independently represent an oxygen atom or a sulfur atom; and from the viewpoint that the effect of the present invention is more excellent, an oxygen atom is preferable.

From the viewpoint that the effect of the present invention is more excellent, the group represented by Formula (A-3) is preferably a group represented by Formula (C-1) or a group represented by Formula (C-2), and more preferably a group represented by Formula (C-3).

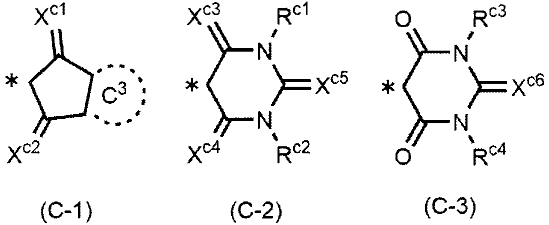

In Formula (C-1), * represents a bonding position.

In Formula (C-1), X^{c1} and X^{c2} each independently represent an oxygen atom or a sulfur atom.

From the viewpoint that the effect of the present invention is more excellent, it is preferable that any one of X^{c1} or X^{c2} is an oxygen atom, and it is more preferable that X^{c1} and X^{c2} are oxygen atoms.

In Formula (C-1), C³ represents an aromatic ring which may have a substituent.

The above-described aromatic ring may be a monocyclic ring or a polycyclic ring.

The number of ring member atoms in the above-described aromatic ring is preferably 4 to 30, more preferably 5 to 12, and still more preferably 5 to 8. The number of ring member atoms in the above-described aromatic ring is the number including the two carbon atoms specified in the formula.

In addition, the aromatic ring may be an aromatic hydrocarbon ring or an aromatic heterocyclic ring, and an aromatic hydrocarbon ring is preferable.

The aromatic ring represented by C³ is as described above; and is preferably a benzene ring, a naphthalene ring, an anthracene ring, a pyrene ring, a thiophene ring, a furan ring, a thiazole ring, an oxazole ring, a pyridine ring, a thienothiophene ring shape, a benzothiophene ring, a benzofuran ring, a pyrazine ring, a pyrimidine ring, or a pyridazine ring, more preferably a benzene ring, a naphthalene ring, or a thiophene ring, and still more preferably a benzene ring.

Examples of the substituent which may be contained in the above-described aromatic ring include the groups exemplified as the substituent W, and an alkyl group or a halogen atom is preferable.

The number of substituents which may be included in the above-described aromatic ring is not particularly limited, but is preferably 0 to 8 and more preferably 0 to 4.

In Formula (C-2), * represents a bonding position.

In Formula (C-2), X^{c3} to X^{c5} each independently represent an oxygen atom or a sulfur atom.

From the viewpoint that the effect of the present invention is more excellent, it is preferable that X^{c3} and X^{c4} are oxygen atoms, and it is more preferable that X^{c3} to X^{c5} are oxygen atoms.

In Formula (C-2), R^{c1} and R^{c2} each independently represent a hydrogen atom or a substituent.

Examples of the above-described substituent include the groups exemplified as the substituent W; and an alkyl group or an aryl group is preferable, and an alkyl group is more preferable.

The above-described alkyl group may be linear, branched, or cyclic, and is preferably linear. The number of carbon atoms in the above-described alkyl group is preferably 1 to 20, more preferably 1 to 6, still more preferably 1 to 3, and particularly preferably 1 or 2.

The above-described aryl group may be a monocyclic ring or a polycyclic ring, and a phenyl group is preferable. The above-described aryl group may further have a substituent, and examples of the substituent include the groups exemplified as the substituent W.

In Formula (C-3), * represents a bonding position.

In Formula (C-3), X^{c6} represents an oxygen atom or a sulfur atom.

From the viewpoint that the effect of the present invention is more excellent, X^{c6} is preferably an oxygen atom.

In Formula (C-3), R^{c3} and R^{c4} each independently represent an aliphatic hydrocarbon group which may have a substituent.

The definition and suitable aspect of the aliphatic hydrocarbon group which may have a substituent, represented by R^{c3} and R^{c4}, are the same as those of the aliphatic hydrocarbon group which may have a substituent, represented by R^{X1} to R^{X5}.

Examples of the substituent which may be included in the aliphatic hydrocarbon group include the substituents exemplified by the above-described substituent W, and a substituent selected from the above-described substituent group S is preferable.

Among these, an alkyl group is preferable as the aliphatic hydrocarbon group which may have a substituent.

The above-described alkyl group may be linear, branched, or cyclic, and is preferably linear. The number of carbon atoms in the above-described alkyl group is preferably 1 to 20, more preferably 1 to 6, still more preferably 1 to 3, and particularly preferably 1 or 2.

In Formula (A-2), * represents a bonding position.

In Formula (A-2), R^{A1} represents a cyano group or -COR^{A2}, and -COR^{A2} is preferable.

R^{A2} represents an aromatic ring group which may have a substituent or an aliphatic hydrocarbon group which may have a substituent.

The definition of the aromatic ring group is as described above, and an aromatic hydrocarbon group is preferable and a phenyl group is more preferable.

The definition of the aliphatic hydrocarbon group is as described above, and an aliphatic hydrocarbon group having 1 to 3 carbon atoms is preferable.

Examples of the substituent which may be included in each group represented by R^{A2} include the substituents exemplified by the above-described substituent W.

Hereinafter, specific examples of the group represented by D in the specific compound will be shown, but the present invention is not limited thereto.

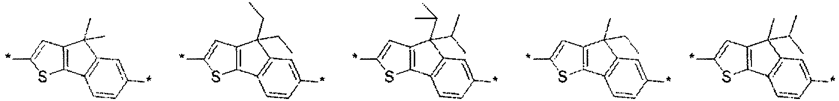

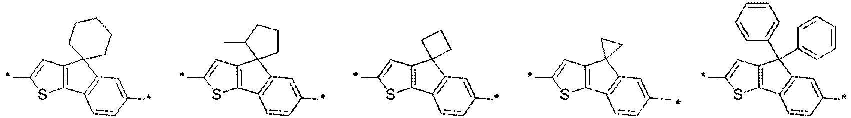

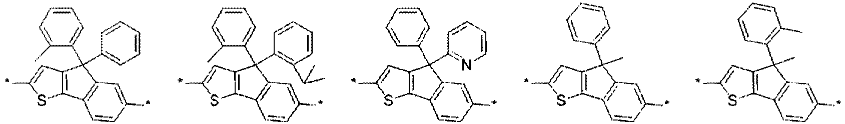

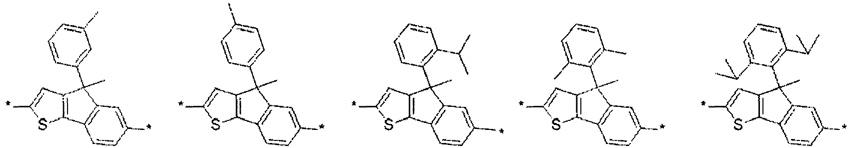

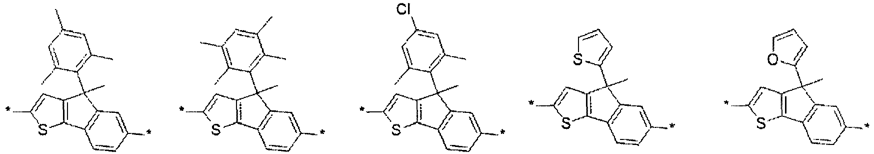

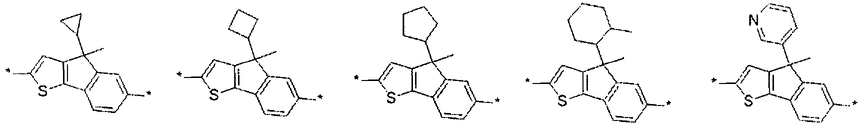

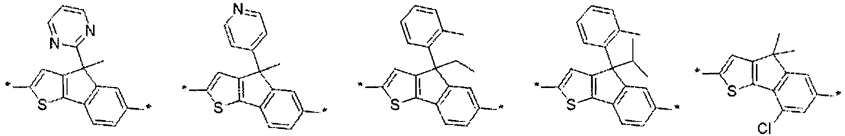

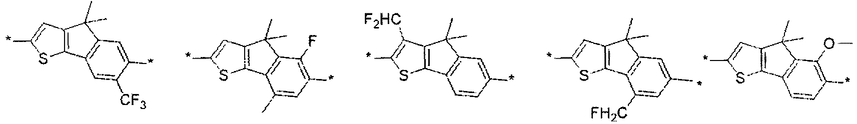

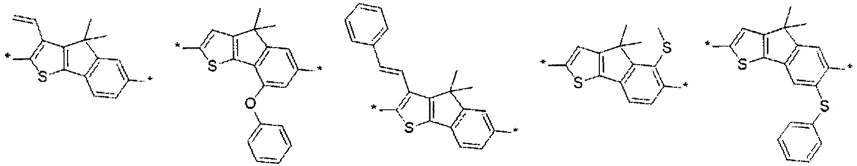

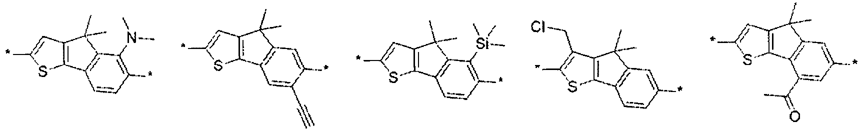

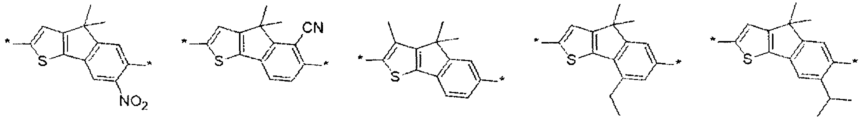

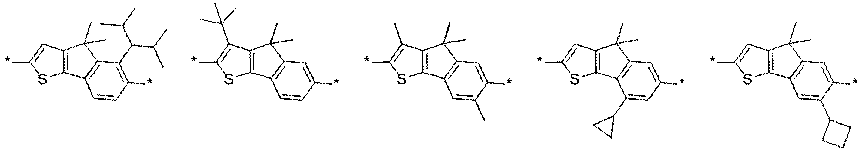

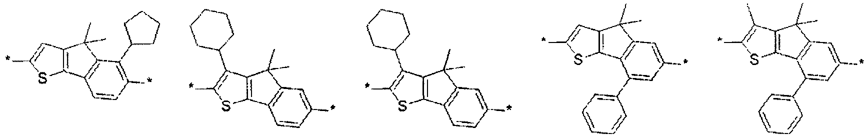

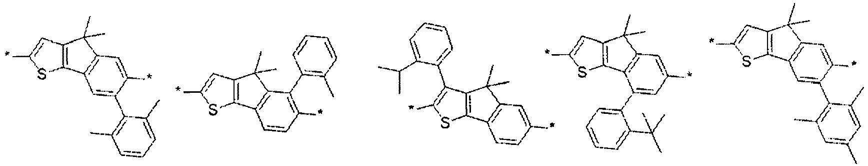

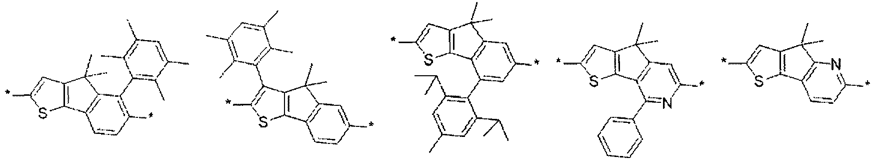

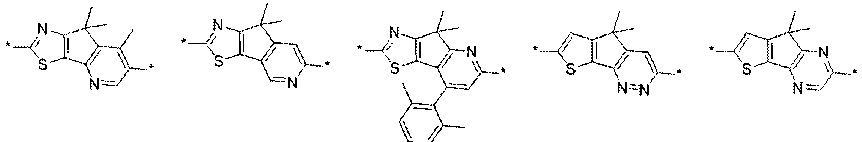

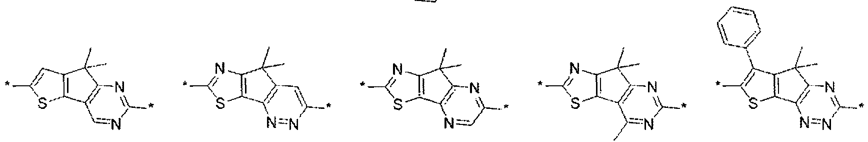

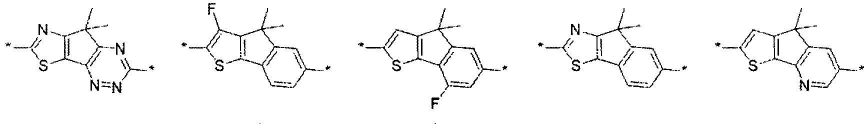

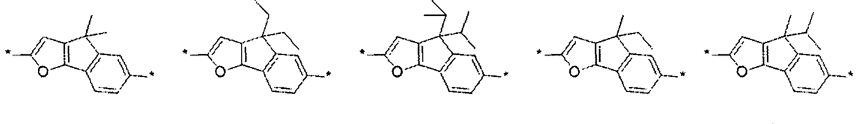

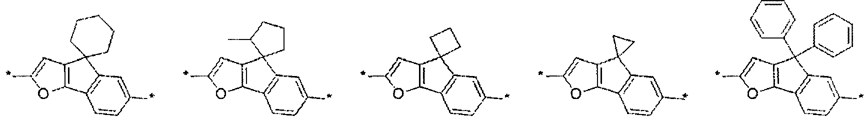

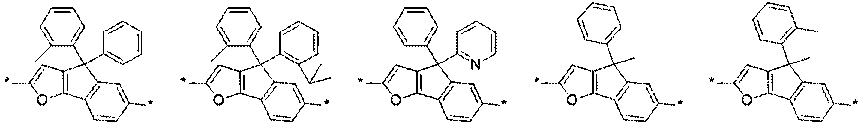

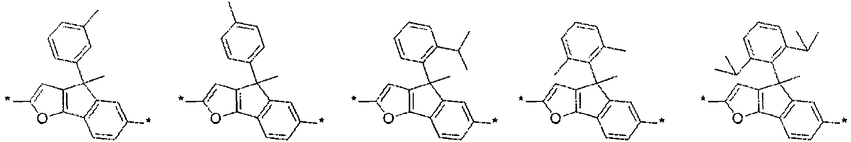

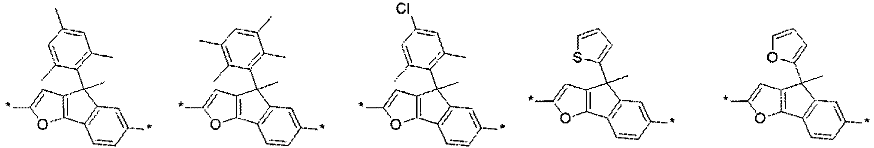

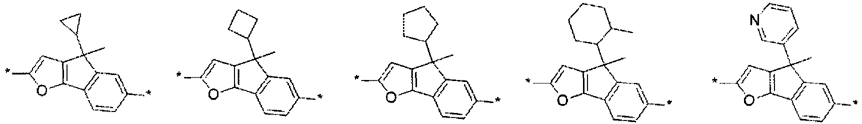

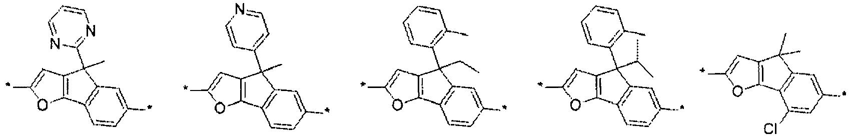

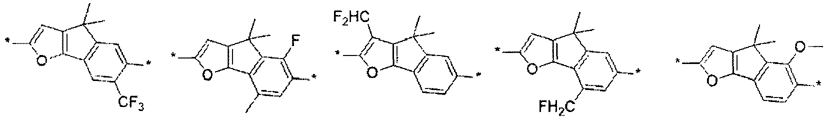

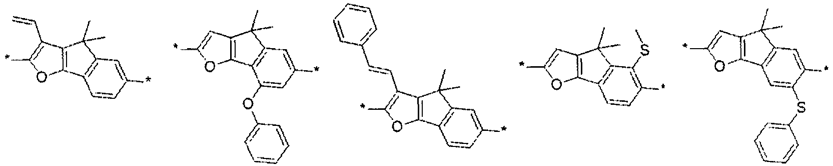

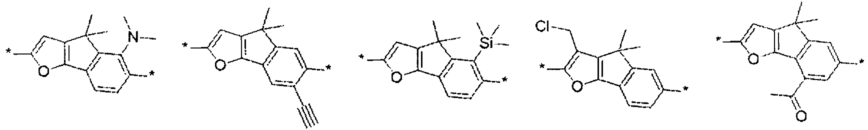

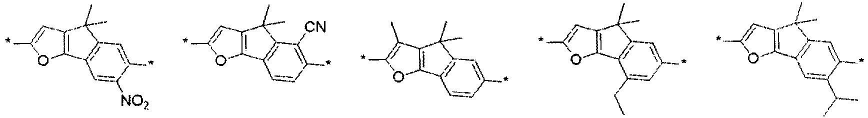

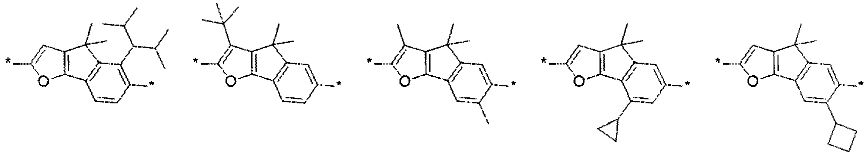

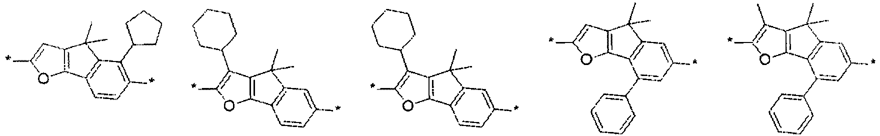

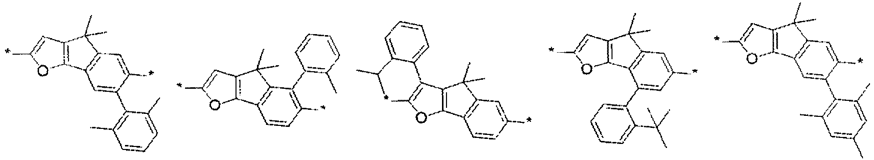

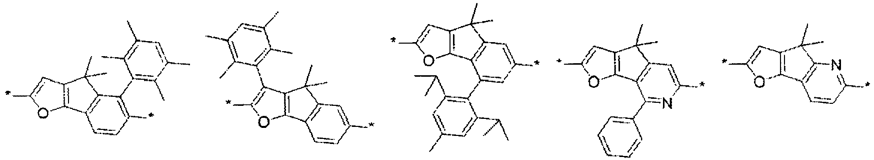

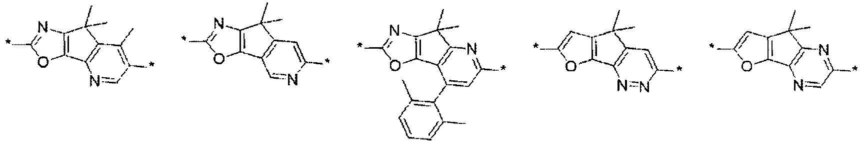

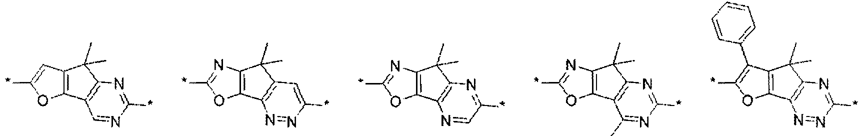

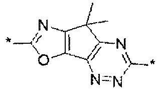

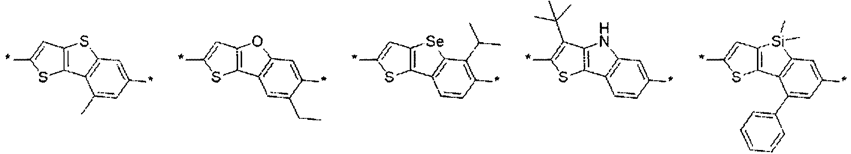

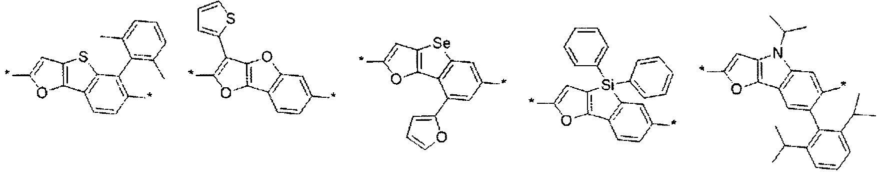

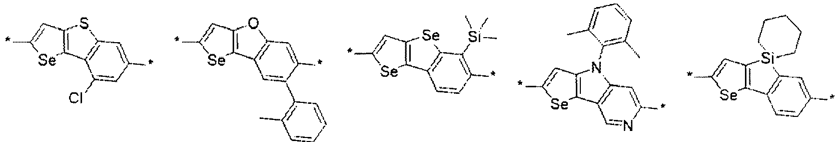

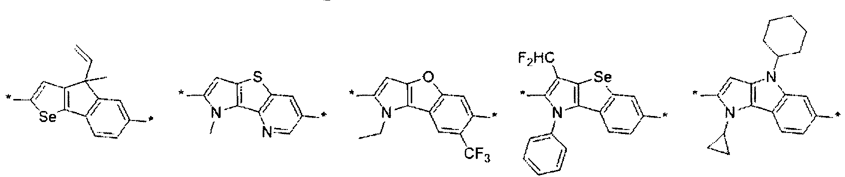

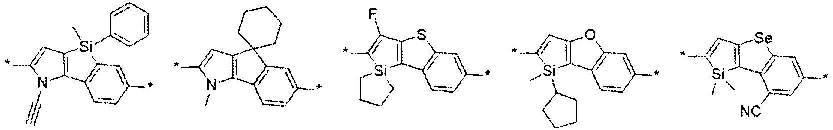

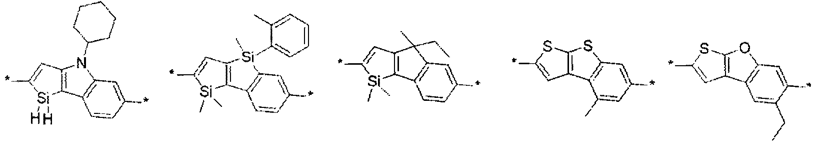

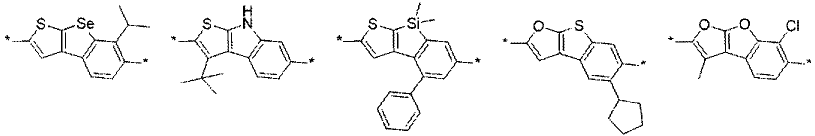

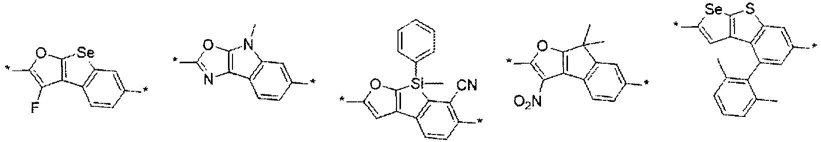

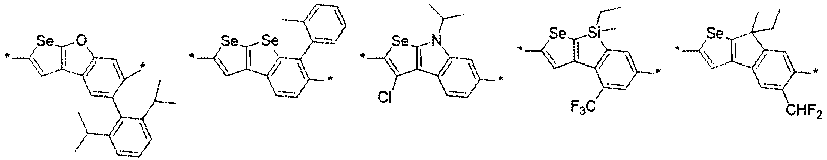

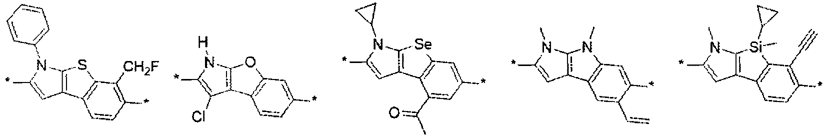

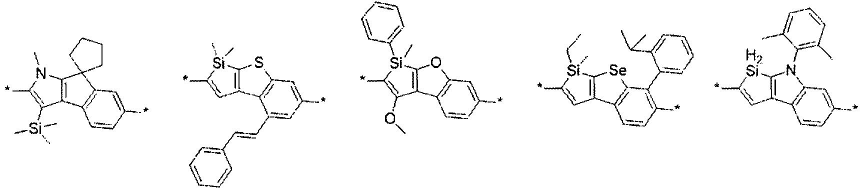

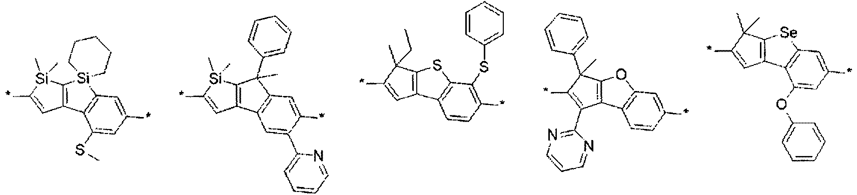

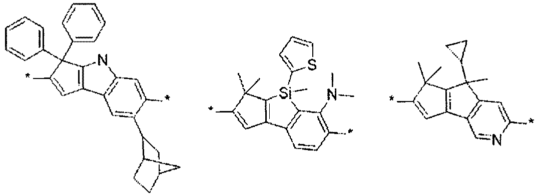

Hereinafter, specific examples of the group represented by Formula (A-1) in the specific compound will be shown, but the present invention is not limited thereto.

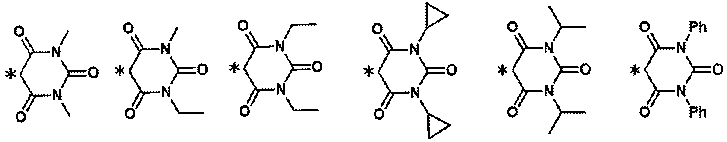

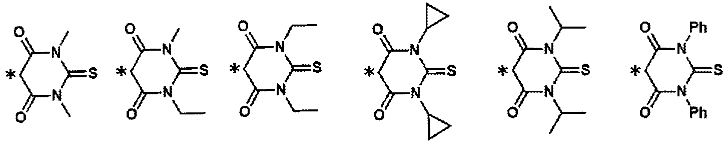

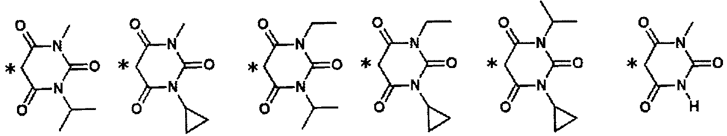

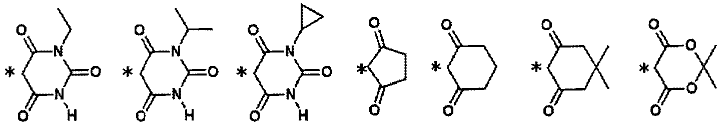

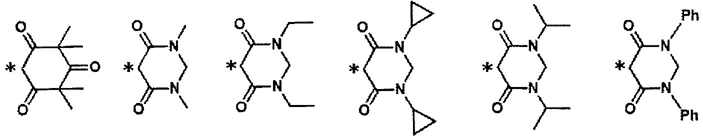

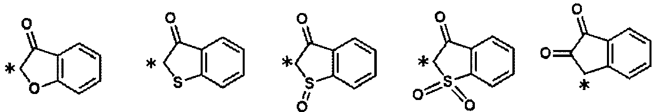

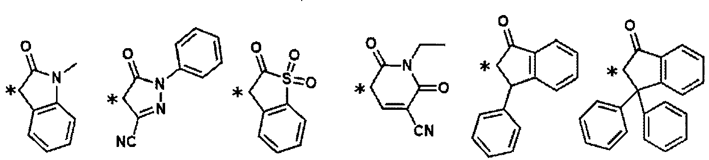

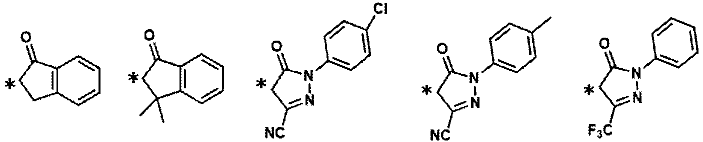

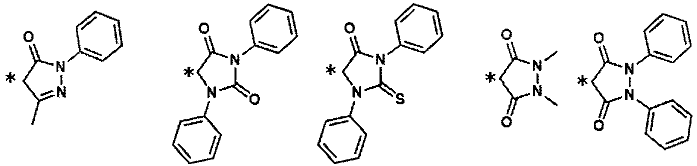

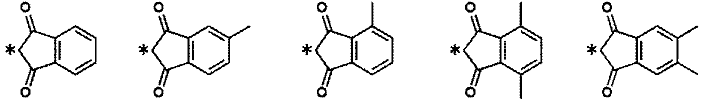

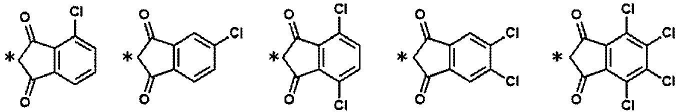

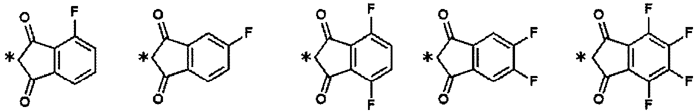

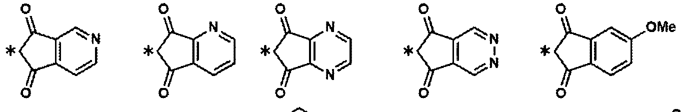

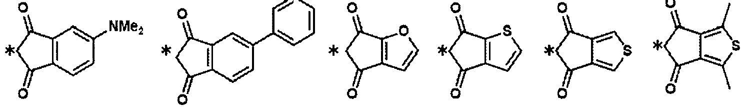

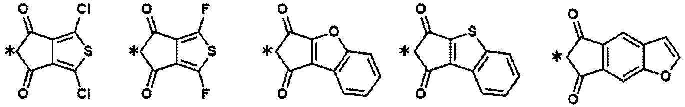

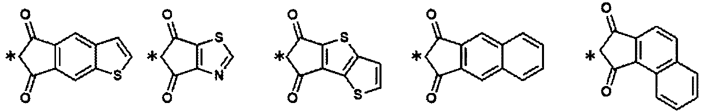

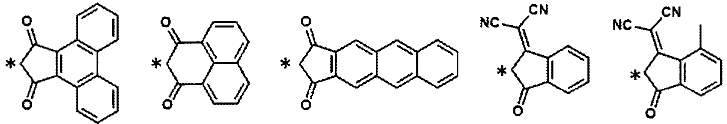

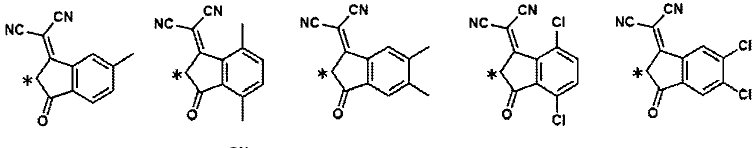

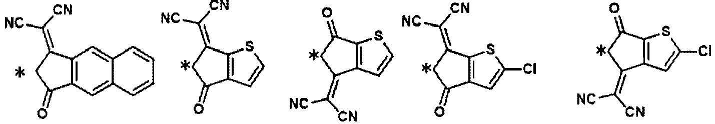

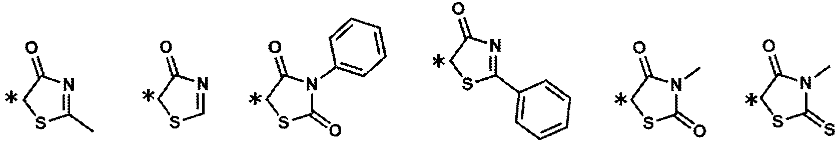

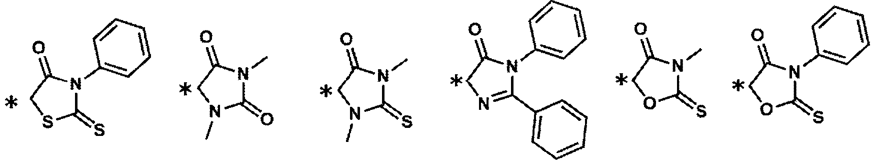

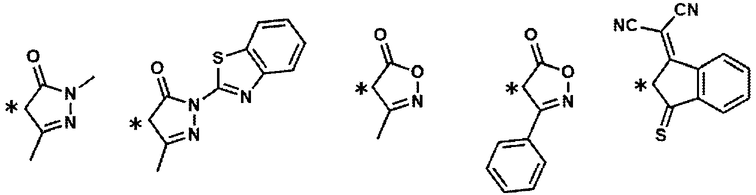

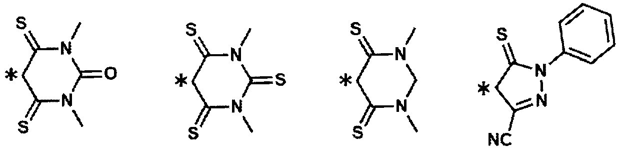

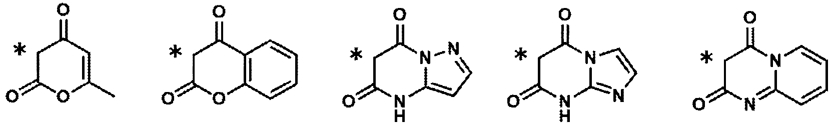

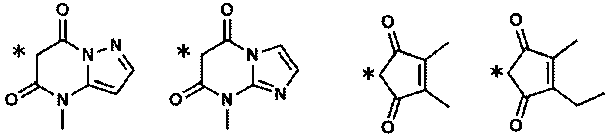

Hereinafter, specific examples of the group represented by Formula (A-2) in the specific compound will be shown, but the present invention is not limited thereto.

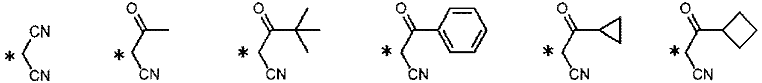

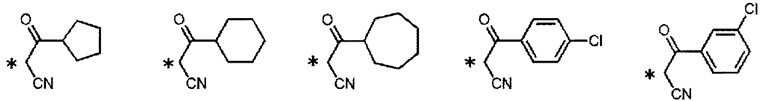

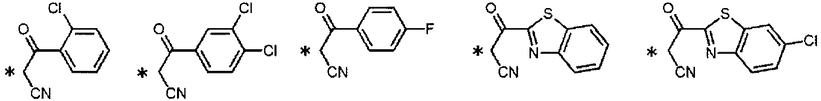

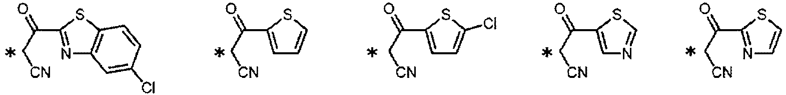

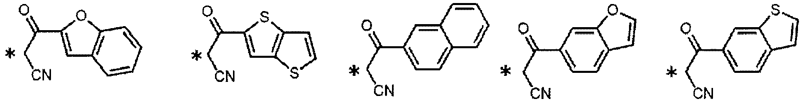

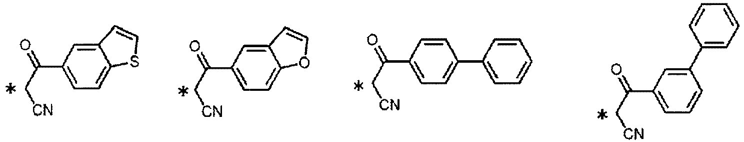

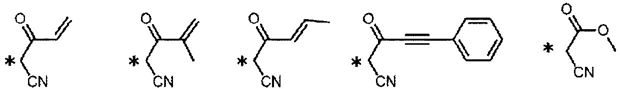

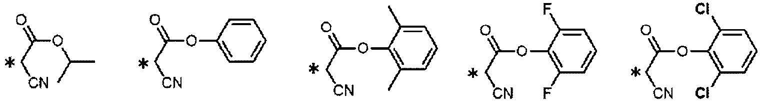

Hereinafter, specific examples of the group represented by Formula (C-3) in the specific compound will be shown, but the present invention is not limited thereto.

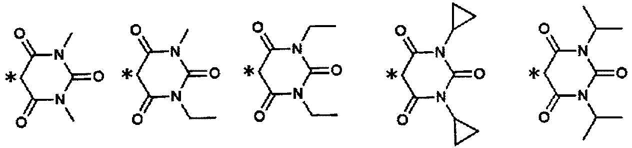

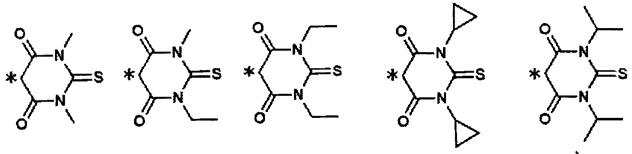

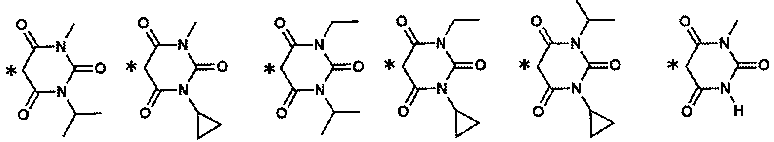

A molecular weight of the specific compound is preferably 300 to 1000, more preferably 350 to 900, and still more preferably 400 to 800.

In a case where the molecular weight is in the above-described range, it is presumed that sublimation temperature of the specific compound is low, and thus the manufacturing suitability is excellent.

From the viewpoint of stability in a case of using the specific compound as a p-type organic semiconductor and matching of energy levels between the specific compound and an n-type organic semiconductor, an ionization potential of the specific compound in a single film is preferably -6.0 to -5.0 eV.

A maximal absorption wavelength of the specific compound is preferably in a wavelength range of 400 to 600 nm, and more preferably in a wavelength range of 400 to 500 nm.

The above-described maximal absorption wavelength is a value measured in a solution state (solvent: chloroform) by adjusting the absorption spectrum of the specific compound to a concentration such that the light absorbance is 0.5 to 1.0. However, in a case where the specific compound is not soluble in chloroform, a value measured by using the specific compound in which the specific compound is vapor-deposited and formed into a film state is defined as the maximal absorption wavelength of the specific compound.

The specific compound is particularly useful as a material of a photoelectric conversion film used for an imaging element, an optical sensor, or a photoelectric cell. The specific compound usually functions as a coloring agent in the photoelectric conversion film. In addition, the specific compound can also be used as a coloring material, a liquid crystal material, an organic semiconductor material, a charge transport material, a pharmaceutical material, and a fluorescent diagnostic material.

The specific compound may be purified as necessary.

Examples of a purification method of the specific compound include sublimation purification, purification using silica gel column chromatography, purification using gel permeation chromatography, re-slurry washing, re-purification by re-precipitation, purification using an adsorbent such as activated carbon, and recrystallization purification.

A content of the specific compound in the photoelectric conversion film (= Film thickness of specific compound in terms of single layer/Film thickness of photoelectric conversion film × 100) is not particularly limited, but is preferably 5% to 75% by volume, more preferably 10% to 50% by volume, and still more preferably 15% to 40% by volume.

The specific compound may be used alone or in combination of two or more types thereof. In a case where two or more types thereof are used, it is preferable that the total amount thereof is within the above-described range.

### <n-type organic semiconductor>

The photoelectric conversion film preferably contains an n-type organic semiconductor, in addition to the specific compound.

The n-type organic semiconductor is a compound different from the above-described specific compound.

The n-type organic semiconductor is an acceptor-type organic semiconductor material (compound), and refers to an organic compound having a property of easily accepting an electron. That is, the n-type organic semiconductor refers to an organic compound having a larger electron affinity in a case where two organic compounds are used in contact with each other. That is, any organic compound having an electron accepting property can be used as the acceptor-type organic semiconductor.

Examples of the n-type organic semiconductor include fullerenes selected from the group consisting of a fullerene and derivatives thereof; fused aromatic carbocyclic compounds (for example, a naphthalene derivative, an anthracene derivative, a phenanthrene derivative, a tetracene derivative, a pyrene derivative, a perylene derivative, a fluoranthene derivative, and the like); heterocyclic compounds with a 5- to 7-membered ring having at least one selected from the group consisting of a nitrogen atom, an oxygen atom, and a sulfur atom (for example, pyridine, pyrazine, pyrimidine, pyridazine, triazine, quinoline, quinoxaline, quinazoline, phthalazine, cinnoline, isoquinoline, pteridine, acridine, phenazine, phenanthroline, tetrazole, pyrazole, imidazole, thiazole, and the like); polyarylene compounds; fluorene compounds; cyclopentadiene compounds; silyl compounds; 1,4,5,8-naphthalenetetracarboxylic acid dianhydride; 1,4,5,8-naphthalenetetracarboxylic acid diimide derivatives; anthraquinodimethane derivatives; diphenylquinone derivatives; bathocuproine, bathophenanthroline, and derivatives thereof; triazole compounds; distyrylarylene derivatives; metal complexes having a nitrogen-containing heterocyclic compound as a ligand; silole compounds; 3,4,9,10-perylenetetracarboxylic dianhydride; 3,4,9,10-perylenetetracarboxylic diimide derivatives; and compounds described in paragraphs [0056] and [0057] of JP2006-100767A.

The n-type organic semiconductor (compound) is preferably fullerenes selected from the group consisting of a fullerene and derivatives thereof.

Examples of the fullerene include a fullerene C₆₀, a fullerene C₇₀, a fullerene C₇₆, a fullerene C₇₈, a fullerene C₈₀, a fullerene C₈₂, a fullerene C₈₄, a fullerene C₉₀, a fullerene C₉₆, a fullerene C₂₄₀, a fullerene C₅₄₀, and a mixed fullerene.

Examples of the derivatives of fullerene include compounds in which a substituent is added to the above-described fullerenes. The above-described substituent is preferably an alkyl group, an aryl group, or a heterocyclic group. As the derivatives of fullerene, compounds described in JP2007-123707A are preferable.

A molecular weight of the n-type organic semiconductor is preferably 200 to 1,200 and more preferably 200 to 900.

A maximal absorption wavelength of the n-type organic semiconductor is preferably in a wavelength of 400 nm or less or in a wavelength range of 400 to 600 nm.

It is preferable that the photoelectric conversion film has a bulk heterojunction structure formed in a state in which the specific compound and the n-type organic semiconductor are mixed with each other. The bulk heterojunction structure refers to a layer in which the specific compound and the n-type organic semiconductor are mixed and dispersed in the photoelectric conversion film. The photoelectric conversion film having the bulk heterojunction structure can be formed by a wet method or a dry method. The bulk heterojunction structure is as described in detail in paragraphs [0013] and [0014] of JP2005-303266A.

A difference in electron affinity between the specific compound and the n-type organic semiconductor is preferably 0.1 eV or more.

The n-type organic semiconductor may be used alone or in combination of two or more types thereof.

In a case where the photoelectric conversion film contains the n-type organic semiconductor, a content of the n-type organic semiconductor in the photoelectric conversion film (Film thickness of n-type organic semiconductor in terms of single layer/Film thickness of photoelectric conversion film × 100) is preferably 15% to 75% by volume, more preferably 20% to 60% by volume, and still more preferably 20% to 50% by volume.

In a case where the n-type organic semiconductor contains fullerenes, a content of the fullerenes to the total content of the n-type organic semiconductor (Film thickness of fullerenes in terms of single layer/Total film thickness of n-type organic semiconductors in terms of single layer × 100) is preferably 50% to 100% by volume, and more preferably 80% to 100% by volume. The fullerenes may be used alone or in combination of two or more types thereof.

From the viewpoint of response speed of the photoelectric conversion element, the content of the specific compound to the total content of the specific compound and the n-type organic semiconductor (Film thickness of specific compound in terms of single layer/(Film thickness of specific compound in terms of single layer + Film thickness of n-type organic semiconductor in terms of single layer) × 100) is preferably 20% to 80% by volume, and more preferably 40% to 80% by volume.

In a case where the photoelectric conversion film contains the n-type organic semiconductor and a p-type organic semiconductor, the content of the specific compound (Film thickness of specific compound in terms of single layer/(Film thickness of specific compound in terms of single layer + Film thickness of n-type organic semiconductor in terms of single layer + Film thickness of p-type organic semiconductor in terms of single layer) × 100) is preferably 10% to 75% by volume, and more preferably 15% to 50% by volume.

It is preferable that the photoelectric conversion film substantially contains the specific compound, the n-type organic semiconductor, and the p-type organic semiconductor contained as desired. The term "substantially" indicates that the total content of the specific compound, the n-type organic semiconductor, and the p-type organic semiconductor is 90% to 100% by volume, preferably 95% to 100% by volume, and more preferably 99% to 100% by volume with respect to the total mass of the photoelectric conversion film.

### <p-type organic semiconductor>

The photoelectric conversion film preferably contains a p-type organic semiconductor in addition to the above-described specific compound.

The p-type organic semiconductor is a compound different from the above-described specific compound.

The p-type organic semiconductor is a donor-type organic semiconductor material (compound), and refers to an organic compound having a property of easily donating an electron. That is, the p-type organic semiconductor refers to an organic compound having a smaller ionization potential in a case where two organic compounds are used in contact with each other.

The p-type organic semiconductor may be used alone or in combination of two or more types thereof.

Examples of the p-type organic semiconductor include a triarylamine compound (for example, N,N'-diphenyl-N,N'-bis(3-methylphenyl)-(1,1'-biphenyl)-4,4'-diamine (TPD), 4,4'-bis[N-(naphthyl)-N-phenyl-amino]biphenyl (α-NPD), compounds described in paragraphs [0128] to [0148] of JP2011-228614A, compounds described in paragraphs [0052] to [0063] of JP2011-176259A, compounds described in paragraphs [0119] to [0158] of JP2011-225544A, compounds described in paragraphs [0044] to [0051] of JP2015-153910A, compounds described in paragraphs [0086] to [0090] of JP2012-094660A, and the like), a pyrazoline compound, a styrylamine compound, a hydrazone compound, a polysilane compound, a thiophene compound (for example, a thienothiophene derivative, a dibenzothiophene derivative, a benzodithiophene derivative, a dithienothiophene derivative, a [1]benzothieno[3,2-b][1]benzothiophene (BTBT) derivative, a thieno[3,2-f:4,5-f]bis[1]benzothiophene (TBBT) derivative, compounds described in paragraphs [0031] to [0036] of JP2018-014474A, compounds described in paragraphs [0043] to [0045] of WO2016/194630A, compounds described in paragraphs [0025] to [0037] and [0099] to [0109] of WO2017/159684A, compounds described in paragraphs [0029] to [0034] of JP2017-076766A, compounds described in paragraphs [0015] to [0025] of WO2018/207722A, compounds described in paragraphs [0045] to [0053] of JP2019-054228A, compounds described in paragraphs [0045] to [0055] of WO2019/058995A,Examples of the metal complex include a metal complex having, as a ligand, a compound described in paragraphs [0063] to [0089] of WO2019/081416A, a compound described in paragraphs [0033] to [0036] of JP2019-80052A, a compound described in paragraphs [0044] to [0054] of WO2019/054125A, a compound described in paragraphs [0041] to [0046]of WO2019/093188A, a compound described in paragraphs [0034] to [0037] of JP2019-050398A, a compound described in paragraphs [0033] to [0036] of JP2018-206878A, a compound described in paragraph [0038] of JP2018-190755A, a compound described in paragraphs [0019] to [0021] of JP2018-026559A, a compound described in paragraphs [0031] to [0056] of JP2018-170487A, a compound described in paragraphs [0036] to [0041] of JP2018-078270A, a compound described in paragraphs [0055] to [0082] of JP2018-166200A, a compound described in paragraphs [0041] to [0050] of JP2018-113425A, a compound described in paragraphs [0044] to [0048] of JP2018-085430A, a compound described in paragraphs [0041] to [0045] of JP2018-056546A, a compound described in paragraphs [0042] to [0049] of JP2018-046267A, a compound described in paragraphs [0031] to [0036] of JP2018-014474A, a compound described in paragraphs [0036] to [0046] of WO2018/016465A, a compound described in paragraphs [0045] to [0048] of JP2020-010024A, a cyanine compound, an oxonol compound, a polyamine compound, an indole compound, a pyrrole compound, a pyrazole compound, a polyarylene compound, a fused aromatic carbon ring compound (for example, a naphthalene derivative, an anthracene derivative, a phenanthrene derivative, a tetracene derivative, a pentacene derivative, a pyrene derivative, a perylene derivative, and a fluoranthene derivative), a porphyrin compound, a phthalocyanine compound, a triazole compound, an oxadiazole compound, an imidazole compound, a polyarylalkane compound, a pyrazolone compound, an amino-substituted chalcone compound, an oxazole compound, a fluorenone compound, a silazane compound, and a nitrogen-containing heterocyclic compound.

In addition, examples of the p-type organic semiconductor also include a benzoxazole compound (for example, compounds described in FIGS. 3 to 7 of JP2022-123944A), a dicarbazole compound (for example, compounds described in FIGS. 2 to 5 of JP2022-122839A), a benzoquinazoline compound (for example, compounds described in paragraphs [0053] to [0056] of JP2022-120323A), an azine compound (for example, compounds described in paragraphs [0041] and [0042] of JP2022-120273A), compounds described in FIGS. 2 to 10 of JP2022-115832A, an indolotriphenylene compound (for example, compounds described in paragraphs [0065] to [0072] of JP2022-108268A), an indolocarbazole compound (for example, compounds described in paragraphs [0052] to [0073] of JP2023-005703A and paragraph [0028] of JP2022-100258A), a triscarbazolylphenyl compound (for example, compounds described in paragraphs [0038] to [0040] of JP2022-181226A), compounds described in paragraphs [0070] to [0082] of JP2022-027575A, and compounds described in paragraphs [0051] to [0064] of JP2021-163968A.

Examples of the p-type organic semiconductor also include compounds having an ionization potential smaller than that of the n-type organic semiconductor, and in a case where this condition is satisfied, the organic coloring agent exemplified as the n-type organic semiconductor can be used.

Compounds which can be used as the p-type organic semiconductor compound are exemplified below.

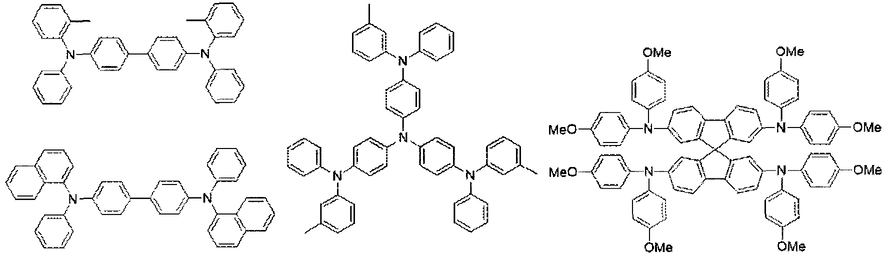

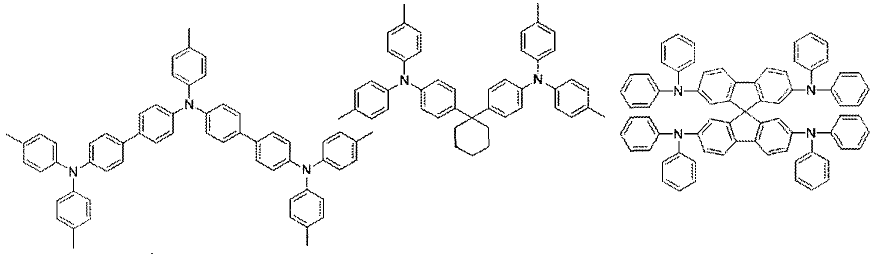

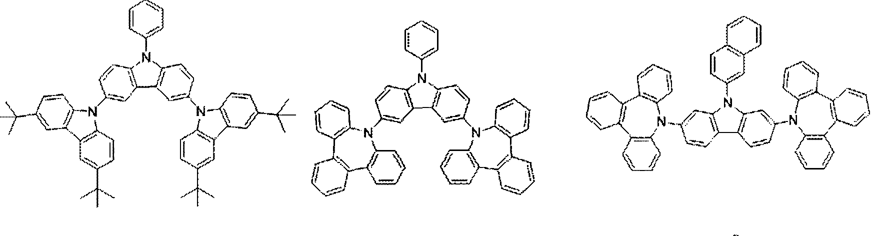

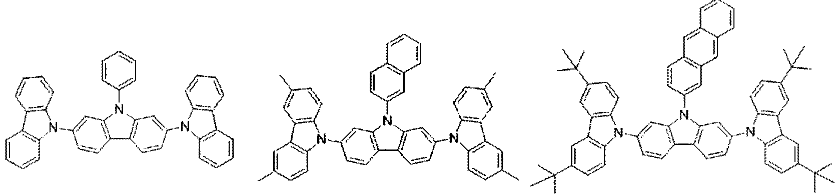

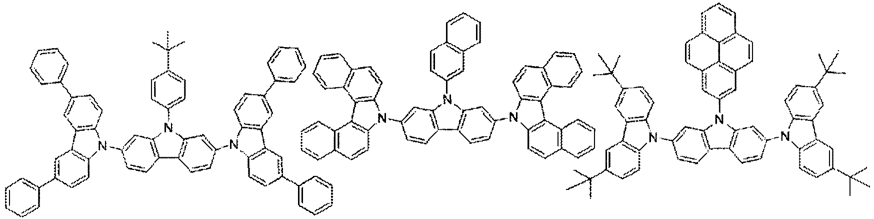

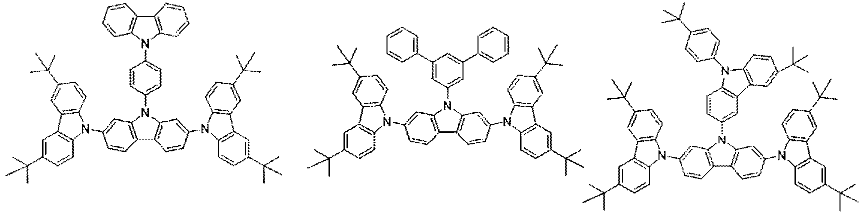

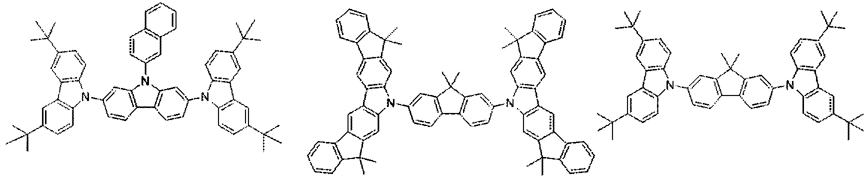

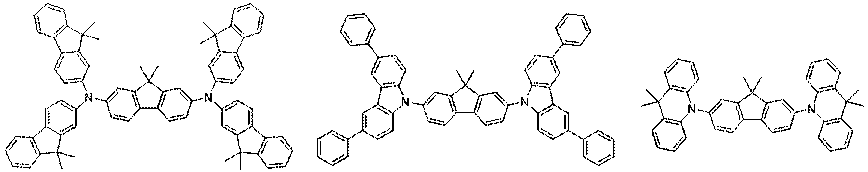

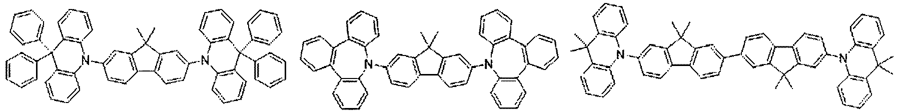

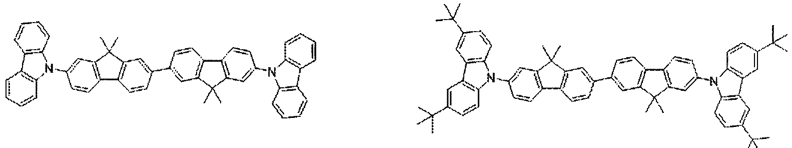

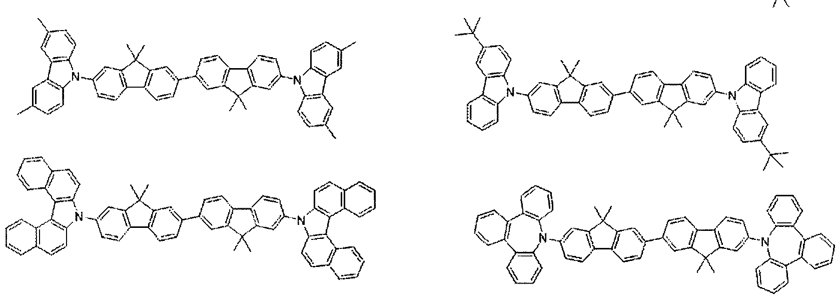

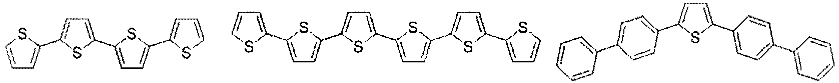

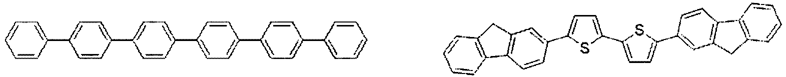

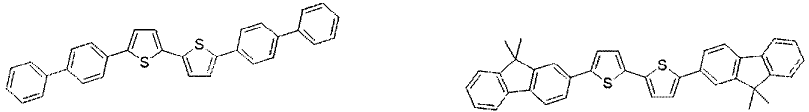

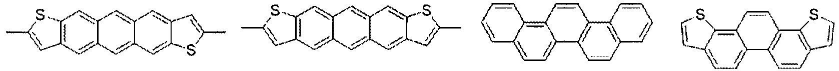

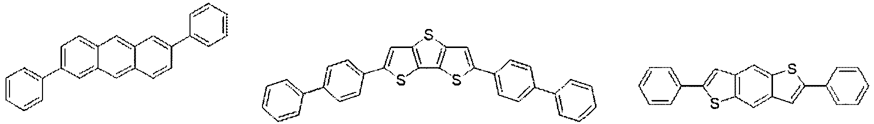

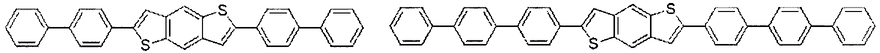

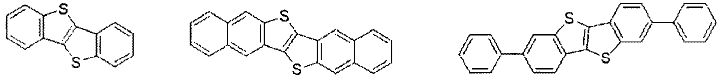

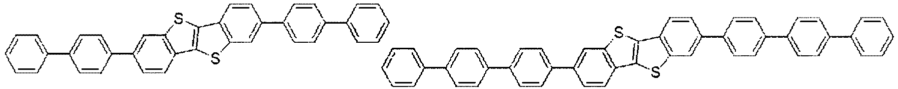

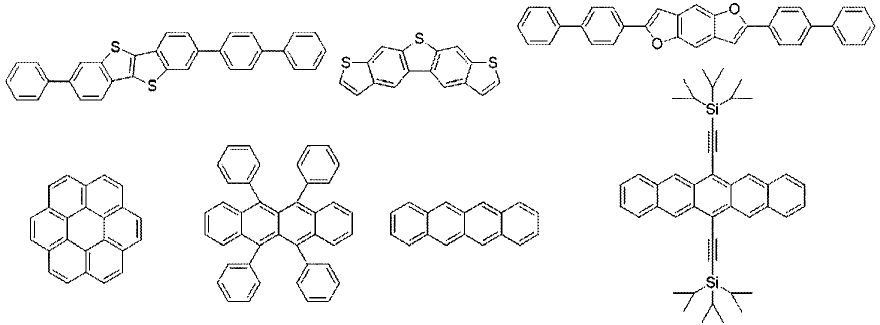

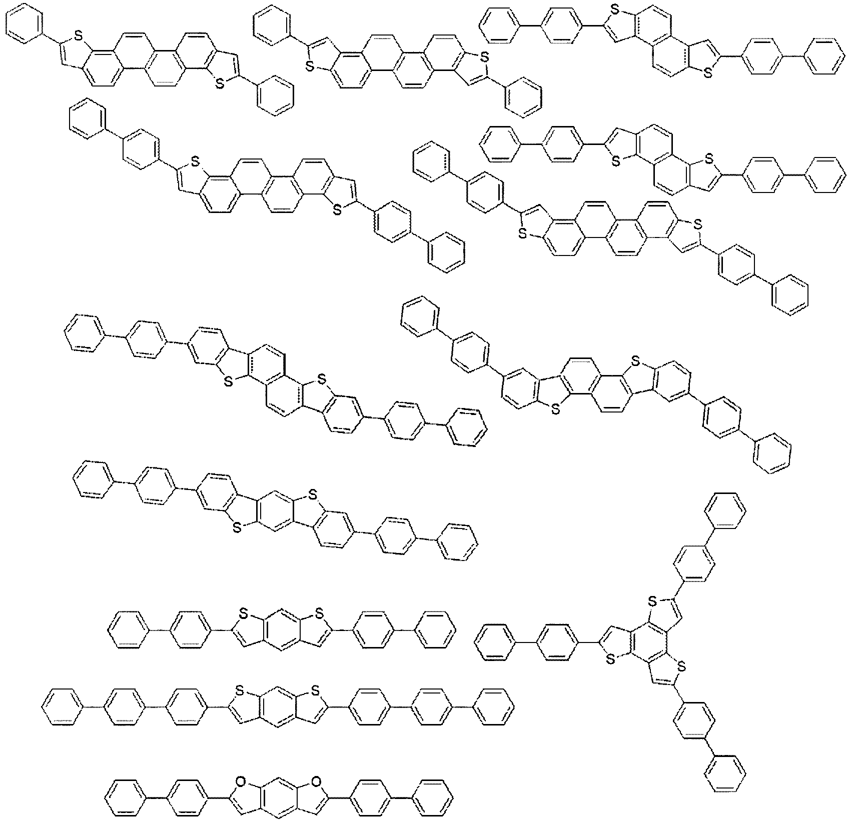

A difference in ionization potential between the specific compound and the p-type organic semiconductor is preferably 0.1 eV or more.

The p-type organic semiconductor material may be used alone or in combination of two or more types thereof.

In a case where the photoelectric conversion film contains the p-type organic semiconductor, a content of the p-type organic semiconductor in the photoelectric conversion film (Film thickness of p-type organic semiconductor in terms of single layer/Film thickness of photoelectric conversion film × 100) is preferably 15% to 75% by volume, more preferably 20% to 60% by volume, and still more preferably 25% to 50% by volume.

The photoelectric conversion film containing the specific compound is a non-luminescent film, and has a feature different from an organic light emitting diode (OLED). The non-luminescent film refers to a film having a light emission quantum efficiency of 1% or less, and the light emission quantum efficiency is preferably 0.5% or less and more preferably 0.1% or less. The lower limit thereof is often 0% or more.

### <Coloring agent>

The photoelectric conversion film preferably contains a coloring agent in addition to the above-described specific compound.

The coloring agent is a compound different from the above-described specific compound.

As the coloring agent, an organic coloring agent is preferable.

Examples of the organic coloring agent include a cyanine coloring agent, a styryl coloring agent, a hemicyanine coloring agent, a merocyanine coloring agent (including zeromethine merocyanine (simple merocyanine)), a rhodacyanine coloring agent, an allopolar coloring agent, an oxonol coloring agent, a hemioxonol coloring agent, a squarylium coloring agent, a croconium coloring agent, an azamethine coloring agent, a coumarin coloring agent, an arylidene coloring agent, an anthraquinone coloring agent, a triphenylmethane coloring agent, an azo coloring agent, an azomethine coloring agent, a metallocene coloring agent, a fluorenone coloring agent, a fulgide coloring agent, a perylene coloring agent, a phenazine coloring agent, a phenothiazine coloring agent, a quinone coloring agent, a diphenylmethane coloring agent, a polyene coloring agent, an acridine coloring agent, an acridinone coloring agent, a diphenylamine coloring agent, a quinophthalone coloring agent, a phenoxazine coloring agent, a phthaloperylene coloring agent, a dioxane coloring agent, a porphyrin coloring agent, a chlorophyll coloring agent, a phthalocyanine coloring agent, a subphthalocyanine coloring agent, a metal complex coloring agent, an imidazoquinoxaline coloring agent described in WO2020/013246A, WO2022/168856A, JP2023-10305A, and JP2023-10299A, and acceptor-donor-acceptor type coloring agent in which two acidic nuclei are bonded to a donor, donor-acceptor-donor type coloring agent in which two donors are bonded to an acceptor, and the like.

Among these, as the organic coloring agent, a cyanine coloring agent, an imidazoquinoxaline coloring agent, or an acceptor-donor-acceptor type coloring agent is preferable.

A maximal absorption wavelength of the coloring agent is preferably in the visible light region, more preferably in a wavelength range of 400 to 650 nm, and still more preferably in a wavelength range of 450 to 650 nm.

The coloring agent may be used alone or in combination of two or more types thereof.

A content of the coloring agent with respect to the total content of the specific compound and the coloring agent in the photoelectric conversion film (= (Film thickness of coloring agent in terms of single layer/(Film thickness of specific compound in terms of single layer + Film thickness of coloring agent in terms of single layer) × 100)) is preferably 5% to 75% by volume, more preferably 5% to 60% by volume, and still more preferably 5% to 50% by volume.

The photoelectric conversion film may further include an optional component in addition to the above-described components.

Examples of the optional component include an antioxidant, a dispersant, and an ultraviolet absorber.

In addition, the optional component may be an impurity derived from the specific compound, the n-type organic semiconductor, the p-type organic semiconductor, or the coloring agent.

In a case where the photoelectric conversion film includes the optional component, a content of the optional component in the photoelectric conversion film (film thickness of the optional component in terms of single layer/film thickness of the photoelectric conversion film × 100) is preferably 0.01 to 10% by volume and more preferably 0.01 to 1% by volume.

### <Film formation method>

Examples of a film formation method of the above-described photoelectric conversion film include a dry film formation method.

Examples of the dry film formation method include a physical vapor deposition method such as a vapor deposition method (particularly, a vacuum vapor deposition method), a sputtering method, an ion plating method, and a molecular beam epitaxy (MBE) method, and a chemical vapor deposition (CVD) method such as plasma polymerization; and a vacuum vapor deposition method is preferable. In a case where the photoelectric conversion film is formed by the vacuum vapor deposition method, manufacturing conditions such as a degree of vacuum and a vapor deposition temperature can be set according to the conventional method.

A film thickness of the photoelectric conversion film is preferably 10 to 1,000 nm, more preferably 50 to 800 nm, and still more preferably 50 to 500 nm.

### [Electrode]

The photoelectric conversion element preferably includes an electrode.

The electrode (the upper electrode (transparent conductive film) 15 and the lower electrode (conductive film) 11) contains a conductive material. Examples of the conductive material include metals, alloys, metal oxides, electrically conductive compounds, and mixtures thereof.

Since light is incident through the upper electrode 15, the upper electrode 15 is preferably transparent to light to be detected. Examples of a material constituting the upper electrode 15 include conductive metal oxides such as tin oxide doped with antimony, fluorine, or the like (antimony tin oxide (ATO) and fluorine doped tin oxide (FTO)), tin oxide, zinc oxide, indium oxide, indium tin oxide (ITO), and indium zinc oxide (IZO); metal thin films such as gold, silver, chromium, and nickel; mixtures or laminates of these metals and the conductive metal oxides; and organic conductive materials such as polyaniline, polythiophene, and polypyrrole; and nano carbon materials such as carbon nanotubes and graphene. From the viewpoint of high conductivity and transparency, conductive metal oxides are preferable.

In general, in a case where the conductive film is thinner than a certain range, a resistance value rapidly increases in many cases. In a solid-state imaging element in which the photoelectric conversion element according to the present embodiment is incorporated, a sheet resistance may be 100 to 10,000 Ω/□, and a degree of freedom of the film thickness range which can be reduced is large.

In addition, as the film thickness of the upper electrode (transparent conductive film) 15 is thinner, the amount of light which is absorbed in the upper electrode is smaller, and thus light transmittance usually increases. The increase in the light transmittance causes an increase in light absorbance in the photoelectric conversion film and an increase in the photoelectric conversion ability, which is preferable. Considering suppression of leakage current, increase in resistance value of the thin film, and increase in transmittance accompanied by the thinning, the thickness of the upper electrode 15 is preferably 5 to 100 nm, and more preferably 5 to 20 nm.

There is a case where the lower electrode 11 has transparency or an opposite case where the lower electrode does not have transparency and reflects light, depending on use. Examples of a material constituting the lower electrode 11 include conductive metal oxides such as tin oxide doped with antimony, fluorine, or the like (ATO and FTO), tin oxide, zinc oxide, indium oxide, indium tin oxide (ITO), and indium zinc oxide (IZO); metals such as gold, silver, chromium, nickel, titanium, tungsten, and aluminum; conductive compounds such as oxides or nitrides of these metals (for example, titanium nitride (TiN)); mixtures or laminates of these metals and conductive metal oxides; organic conductive materials such as polyaniline, polythiophene, and polypyrrole; and carbon materials such as carbon nanotubes and graphene.

A method of forming the electrode can be appropriately selected in accordance with the electrode material. Specific examples thereof include a wet method such as a printing method and a coating method; a physical method such as a vacuum vapor deposition method, a sputtering method, and an ion plating method; and a chemical method such as a CVD method and a plasma CVD method.

In a case where the electrode material is ITO, examples thereof include an electron beam method, a sputtering method, a resistance thermal vapor deposition method, a chemical reaction method (such as a sol-gel method), and a coating method with a dispersion of indium tin oxide.

### [Charge blocking film: electron blocking film and hole blocking film]

It is preferable that the photoelectric conversion element includes one or more interlayers between the conductive film and the transparent conductive film, in addition to the photoelectric conversion film.

Examples of the above-described interlayer include a charge blocking film. In a case where the photoelectric conversion element includes the film, the characteristics (such as the quantum efficiency and the response speed) of the photoelectric conversion element to be obtained are more excellent. Examples of the charge blocking film include an electron blocking film and a hole blocking film.

### <Electron blocking film>

The electron blocking film is a donor-type organic semiconductor material (compound), and the above-described p-type organic semiconductor can be used.

In addition, a polymer material can also be used in the electron blocking film.

Specific examples of the polymer material include a polymer such as phenylenevinylene, fluorene, carbazole, indole, pyrene, pyrrole, picoline, thiophene, acetylene, and diacetylene, and derivatives thereof.

The electron blocking film may be configured by a plurality of films.

The electron blocking film may be formed of an inorganic material. In general, since an inorganic material has a dielectric constant larger than that of an organic material, in a case where the inorganic material is used in the electron blocking film, a large voltage is applied to the photoelectric conversion film. Therefore, the quantum efficiency increases. Examples of the inorganic material which can be used in the electron blocking film include calcium oxide, chromium oxide, copper chromium oxide, manganese oxide, cobalt oxide, nickel oxide, copper oxide, copper gallium oxide, copper strontium oxide, niobium oxide, molybdenum oxide, copper indium oxide, silver indium oxide, and iridium oxide.

### <Hole blocking film>

The hole blocking film is an acceptor-type organic semiconductor material (compound), and the above-described n-type organic semiconductor can be used.

The hole blocking film may be configured by a plurality of films.

Examples of a method of manufacturing the charge blocking film include a dry film formation method and a wet film formation method. Examples of the dry film formation method include a vapor deposition method and a sputtering method. The vapor deposition method may be a physical vapor deposition (PVD) method or a chemical vapor deposition (CVD) method, and a physical vapor deposition method such as a vacuum vapor deposition method is preferable. Examples of the wet film formation method include an ink jet method, a spray method, a nozzle printing method, a spin coating method, a dip coating method, a casting method, a die coating method, a roll coating method, a bar coating method, and a gravure coating method; and an inkjet method is preferable from the viewpoint of high-precision patterning.

Each film thickness of the charge blocking films (the electron blocking film and the hole blocking film) is preferably 3 to 200 nm, more preferably 5 to 100 nm, and still more preferably 5 to 30 nm.

### [Substrate]

The photoelectric conversion element may further include a substrate.

Examples of the substrate include a semiconductor substrate, a glass substrate, and a plastic substrate.

As a position of the substrate, in general, the conductive film, the photoelectric conversion film, and the transparent conductive film are laminated on the substrate in this order.

### [Sealing layer]

The photoelectric conversion element may further include a sealing layer.

The performance of the photoelectric conversion material may deteriorate significantly due to the presence of deterioration factors such as water molecules. The deterioration can be prevented by coating and sealing the entirety of the photoelectric conversion film with a sealing layer such as diamond-like carbon (DLC) and ceramics such as metal oxide, metal nitride, or metal nitride oxide, which are dense and into which water molecules do not permeate.

Examples of the sealing layer include the description in paragraphs [0210] to [0215] of JP2011-082508A, the contents of which are incorporated herein by reference.

### [Manufacturing method of photoelectric conversion element]

Examples of a method for manufacturing the photoelectric conversion element include known manufacturing methods.

Specific examples thereof include a method for manufacturing the photoelectric conversion element, which includes a step of forming the conductive film on the substrate, a step of forming the photoelectric conversion film, and a step of forming the transparent conductive film.

The method for manufacturing the photoelectric conversion element may include a step other than the above-described steps (for example, a step of forming the charge blocking film and a step of forming the sealing layer).

The method of forming each layer is as described above.

### [Imaging element]

Examples of the application of the photoelectric conversion element include an imaging element.

The imaging element is an element which converts optical information of an image into the electric signal, and is usually an element in which a plurality of photoelectric conversion elements are arranged in a matrix shape on the same plane, optical signals are converted into electric signals in each photoelectric conversion element (a pixel), and the electric signals can be sequentially output to the outside of the imaging elements for each pixel. Therefore, each pixel is formed of one or more photoelectric conversion elements and one or more transistors.

A manufacturing method of the imaging element is not particularly limited, and examples thereof include a method including a step of manufacturing the above-described photoelectric conversion element.

### [Optical sensor]

Examples of another application of the photoelectric conversion element include a photoelectric cell and an optical sensor, but it is preferable that the photoelectric conversion element according to the embodiment of the present invention is used as the optical sensor. The above-described photoelectric conversion element may be used alone as the optical sensor, or may be used as a line sensor in which the photoelectric conversion elements are linearly arranged or as a two-dimensional sensor in which the photoelectric conversion elements are arranged on a plane.

### [Compound]

The present invention also includes the specific compound.

### Examples

Hereinafter, the present invention will be described in more detail with reference to Examples.

The materials, the amounts of materials used, the proportions, the treatment details, the treatment procedure, and the like shown in Examples below may be modified as appropriate as long as the modifications do not depart from the spirit of the present invention. Therefore, the scope of the present invention should not be construed as being limited to Examples shown below.

### [Compound used for photoelectric conversion film]

Hereinafter, each material used for a photoelectric conversion film is shown.

### [Synthesis of compound (B-1)]

A compound (B-1) was synthesized according to the following scheme.

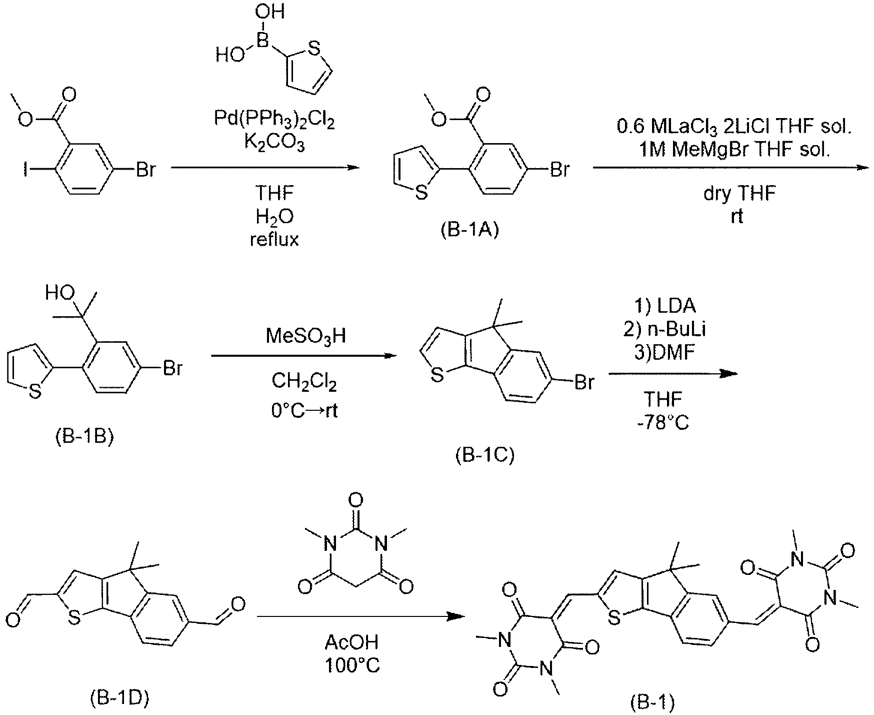

### <Synthesis of intermediate (B-1A)>

Methyl 5-bromo-2-iodobenzoate (30 g), 2-thiopheneboronic acid (14.6 g), potassium carbonate (K₂CO₃, 24.3 g), tetrahydrofuran (THF, 352 mL), and water (70 mL) were charged into a round-bottom flask, nitrogen substitution (3 times) was performed, and then dichlorobis(triphenylphosphine)palladium (II) (Pd(PPh₃)₂Cl₂, 3.09 g) was added thereto, and nitrogen substitution (2 times) was performed.

The reaction solution was heated and stirred at 70°C for 3 hours under a nitrogen atmosphere, cooled to room temperature, and then filtered through Celite. The filtrate was separated into an aqueous phase and an organic phase, the aqueous phase was extracted with ethyl acetate, the combined organic phase was washed with saturated saline, dried with sodium sulfate, and the solvent was distilled off under reduced pressure. The obtained crude product was purified by silica gel column chromatography (eluent: n-hexane/ethyl acetate = 98/2 → 9/1), thereby obtaining 22.4 g of the intermediate (B-1A) (yield: 86%).

¹H-NMR (Nuclear Magnetic Resonance) data of the intermediate (B-1A) is shown below.

¹H-NMR(CDCl₃):δ(ppm) = 7.86(s,1H), 7.61(d,1H), 7.36(d,1H), 7.35(d,1H), 7.07-7.02(m,2H), 3.75(s,1H).

### <Synthesis of intermediate (B-1B)>

The intermediate (B-1A) (21.2 g), dehydrated THF (396 mL), and a lanthanum (III) bis(chloride lithium) complex (THF solution (0.6 M), 130 mL) were charged into a round-bottom flask.

Under a nitrogen atmosphere, methylmagnesium bromide (THF solution (12%), 210 mL) was added dropwise at room temperature, stirred at room temperature for 30 minutes, and then an ammonium chloride aqueous solution (21 mL), water (42 mL), and a 1 M hydrochloric acid aqueous solution (250 mL) were added thereto. The obtained reaction solution was extracted with ethyl acetate, the recovered organic phase was washed with saturated saline, dried with sodium sulfate, and the solvent was distilled off under reduced pressure, thereby obtaining 21.2 g of the intermediate (B-1B) (yield: 100%).

¹H-NMR data of the intermediate (B-1B) is shown below.

¹H-NMR(CDCl₃):δ(ppm) = 7.84(s,1H), 7.37(d,1H), 7.35(d,1H), 7.09(d,1H), 7.04(t,1H), 7.00(d,1H), 1.51(s,6H).

### <Synthesis of intermediate (B-1C)>

The intermediate (B-1B) (21.2 g) and dichloromethane (1425 mL) were charged into a round-bottom flask. Under a nitrogen atmosphere, the reaction solution was cooled to 0°C, methanesulfonic acid (28 mL) was added thereto, and stirred for 30 minutes, and water (212 mL) was added thereto.

The obtained reaction solution was washed with water, the recovered organic phase was washed with saturated saline, dried with sodium sulfate, and the solvent was distilled off under reduced pressure. The obtained crude product was purified by silica gel column chromatography (eluent: n-hexane/ethyl acetate = 99/1) to obtain 19.9 g (yield: 87%) of an intermediate (B-1C).

¹H-NMR data of the intermediate (B-1C) is shown below.

¹H-NMR(CDCl₃):δ(ppm) = 7.47(s,1H), 7.39(d,1H), 7.32(d,1H), 7.27(d,1H), 7.01(d,IH), 1.45(s,6H).

### <Synthesis of intermediate (B-1D)>

The intermediate (B-1C) (1.0 g) and tetrahydrofuran (THF, 36 mL) were charged into a round-bottom flask, and under a nitrogen atmosphere, the reaction solution was cooled to - 78°C, lithium diisopropylamide (n-hexane-THF solution (1.0 M), 10 mL) was added dropwise thereto, stirred at -78°C for 1 hour, n-butyllithium (hexane solution (1.6 M), 6.7 mL) was added dropwise thereto, and stirred at -78°C for 1 hour.

N,N-dimethylformamide (DMF, 2.8 mL) was added thereto, the temperature was raised to room temperature, and then an ammonium chloride aqueous solution (30 mL) was added thereto. The obtained reaction solution was extracted with ethyl acetate, the recovered organic phase was washed with a 1 M hydrochloric acid aqueous solution and saturated saline in this order, dried with sodium sulfate, and the solvent was distilled off under reduced pressure. The obtained crude product was purified by silica gel column chromatography (eluent: toluene/ethyl acetate = 97/3) to obtain 0.92 g (yield: 70%) of an intermediate (B-1D).

¹H-NMR data of the intermediate (B-1D) is shown below.

¹H-NMR(CDCl₃):δ(ppm) = 10.06(s,1H), 9.94(s,1H), 7.95(s,1H), 7.87(d,1H), 7.74(s,1H), 7.71(d,1H), 1.56(s,6H).

### <Synthesis of compound (B-1)>

The intermediate (B-1D) (300 mg), 1,3-dimethylbarbituric acid (475 mg), acetic acid (30 mL), and piperidine (46 µL) were charged into a round-bottom flask, and the mixture was reacted at 100°C for 2 hours under a nitrogen atmosphere.

The reaction solution was cooled to room temperature, the precipitated solid was filtered off, and the obtained crude product was recrystallized with chloroform/HFIP (hexafluoro-2-propanol)/toluene. The obtained solid was purified by sublimation, thereby obtaining 449 mg of the compound (B-1) (yield: 72%).

¹H-NMR data of the compound (B-1) is shown below.

¹H-NMR(CDCl₃):δ(ppm) = 8.75(1H, s), 8.61(1H, s), 8.26(1H, s), 8.15(1H, d), 7.83(1H, s), 7.71(1H, d), 3.47(3H, s), 3.45(3H, s), 3.44(3H, s), 3.41(3H, s), 1.59(6H, s).

Compounds of each of Examples and Comparative Examples, which were used in a photoelectric conversion film, other than the compound (B-1), were synthesized according to the synthesis method of the compound (B-1).

### [Specific compound]

The specific compounds used for the photoelectric conversion film and comparative compounds of Comparative Examples are shown below.

The compounds (B-1) to (B-37) are specific compounds, and the compounds (C-1) to (C-5) are comparative compounds.

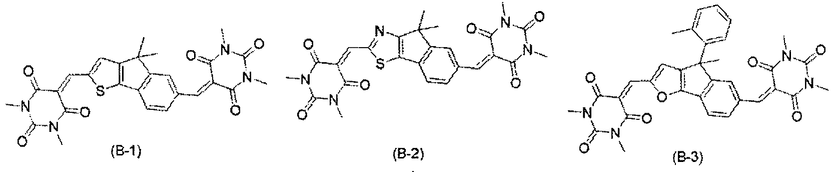

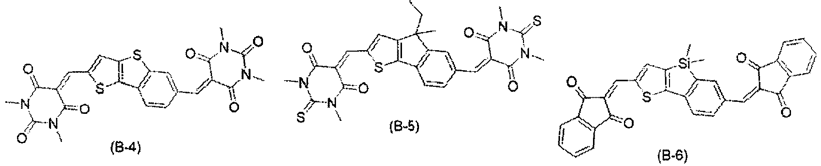

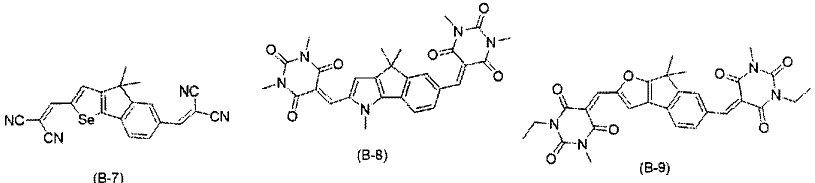

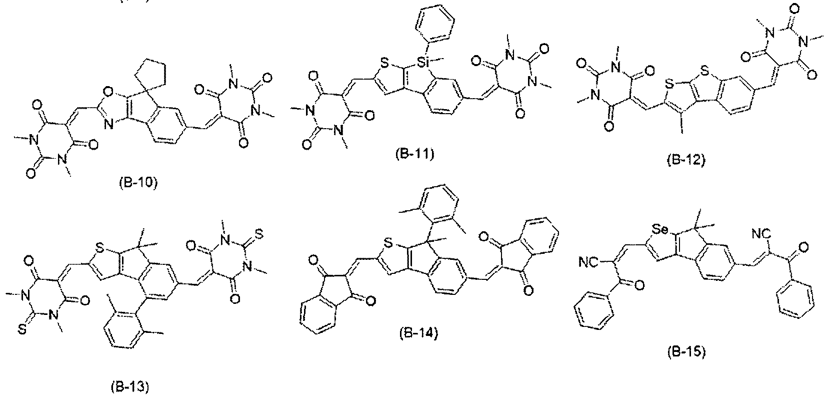

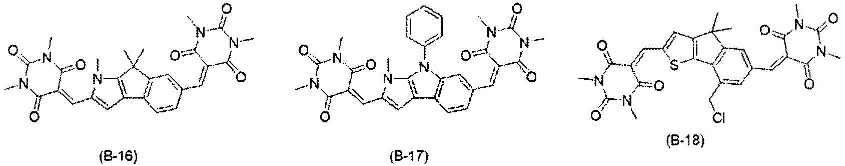

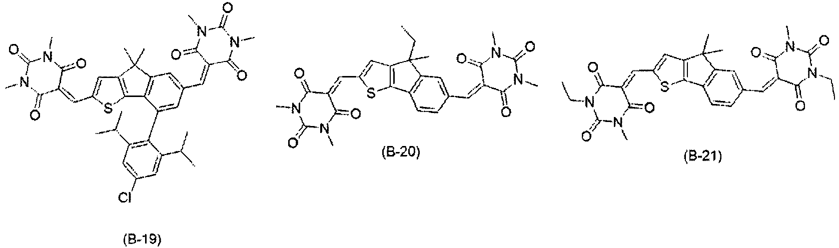

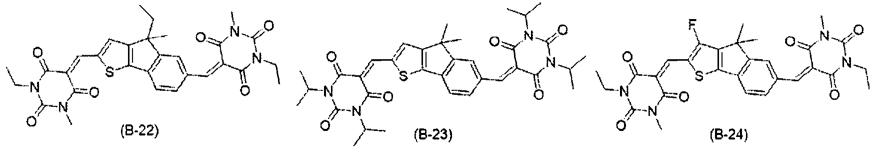

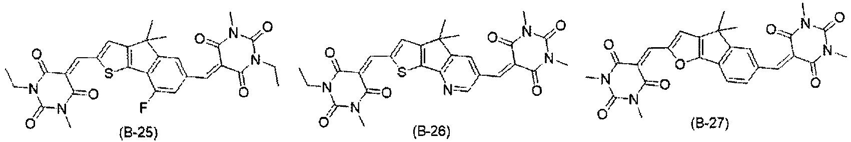

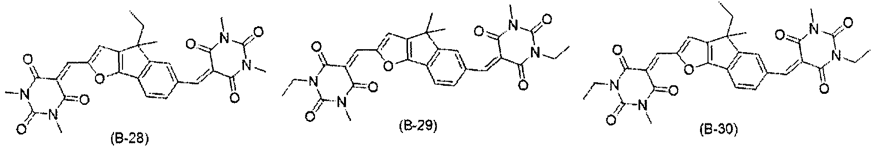

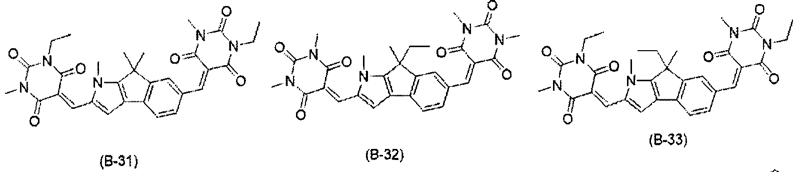

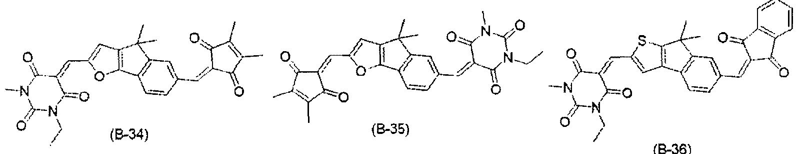

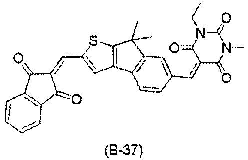

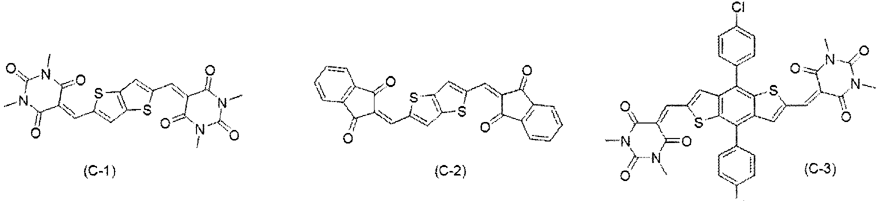

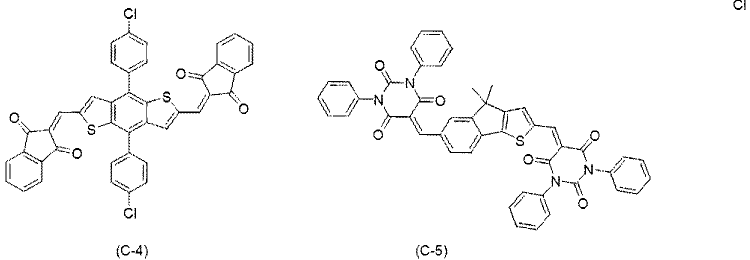

### [n-type organic semiconductor]

### · Fullerene (C₆₀)

### [p-type organic semiconductor]

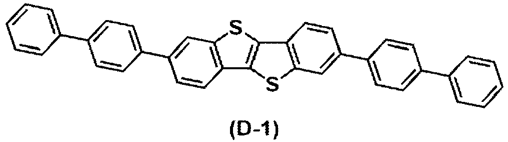

### [Coloring agent]

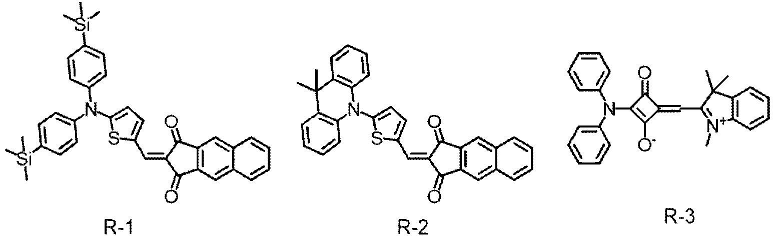

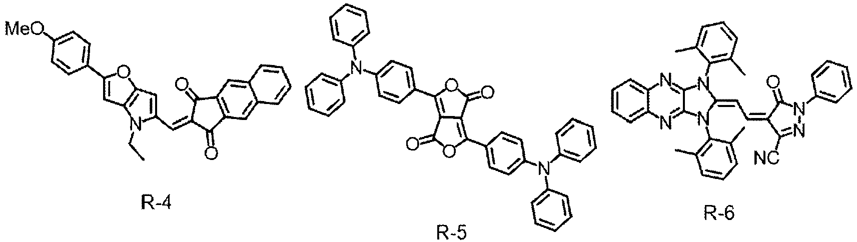

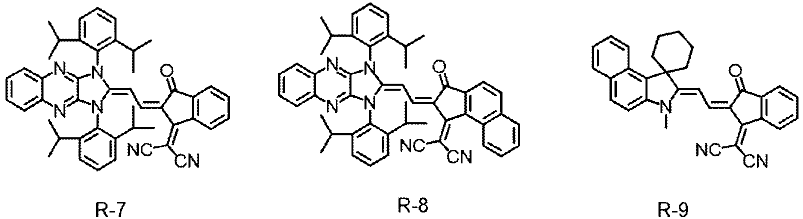

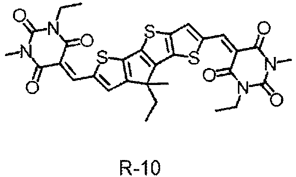

### [Evaluation]

The quantum efficiency (sensitivity) of the photoelectric conversion element in a case of receiving blue-green light, the electric field strength dependence of the quantum efficiency, the response speed, and the manufacturing suitability were evaluated by the following method.

### [Production of photoelectric conversion element]

A photoelectric conversion element having the form of FIG. 2 was produced using the various components shown above. Here, the photoelectric conversion element included a lower electrode 11, an electron blocking film 16A, a photoelectric conversion film 12, a hole blocking film 16B, and an upper electrode 15.

Specifically, an amorphous ITO film was formed on a glass substrate by a sputtering method to form the lower electrode 11 (thickness: 30 nm), and the compound (EB-1) was further formed into a film on the lower electrode 11 by a vacuum thermal vapor deposition method to form the electron blocking film 16A (thickness: 30 nm).

Subsequently, the glass substrate was subjected to a vacuum vapor deposition method in a state of room temperature to form a film on the electron blocking film 16A by co-vapor deposition, by a vacuum vapor deposition method, of each specific compound or each comparative compound shown in Table 1, the n-type organic semiconductor (fullerene (C₆₀)), and the p-type organic semiconductor (D-1) so that the thicknesses in terms of single layers were in a ratio of 1:1:1. As a result, the photoelectric conversion film 12 having a bulk heterojunction structure with a thickness of 400 nm was formed. In this case, a film formation rate of the photoelectric conversion film 12 was set to 1.0 Å/sec.

Furthermore, the compound (EB-2) was vapor-deposited on the photoelectric conversion film 12 to form the hole blocking film 16B (thickness: 10 nm). Amorphous ITO was formed into a film on the hole blocking film 16B by a sputtering method to form the upper electrode 15 (transparent conductive film) (thickness: 10 nm). An SiO film was formed as a sealing layer on the upper electrode 15 by a vacuum vapor deposition method, an aluminum oxide (Al₂O₃) layer was formed thereon by an atomic layer chemical vapor deposition (ALCVD) method, and the obtained laminate was heated in a glove box at 150°C for 30 minutes to obtain a photoelectric conversion element.

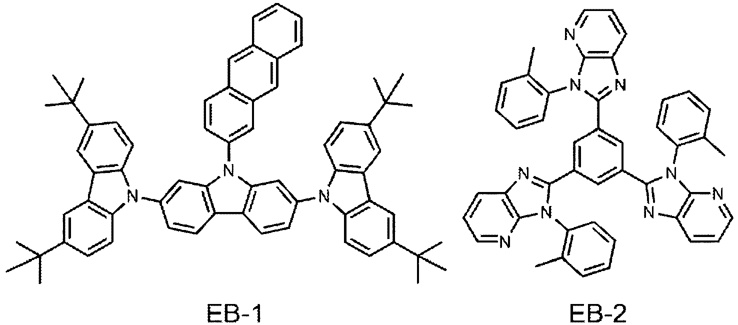

### [Dark current]

A dark current of each obtained photoelectric conversion element was measured by the following method.

A voltage was applied to the lower electrode and the upper electrode of each of the photoelectric conversion elements with an electric field strength of 2.5 × 10⁵ V/cm, and a current value (dark current) in a dark place was measured. As a result, it was confirmed that all of the photoelectric conversion elements had a dark current of 50 nA/cm² or less, which indicates that all of the photoelectric conversion elements had a sufficiently low dark current.

### [Quantum efficiency]

For each photoelectric conversion element, a quantum efficiency in a case of receiving blue-green light was measured by the following method.

A voltage was applied to each photoelectric conversion element with an electric field strength of 2.0 × 10⁵ V/cm, and then light was emitted from the upper electrode (transparent conductive film) side to evaluate quantum efficiency (photoelectric conversion efficiency) at a wavelength of 460 nm. The quantum efficiency (relative ratio) was calculated according to Formula (S1). From the obtained values, the quantum efficiency was evaluated according to the following evaluation standard. 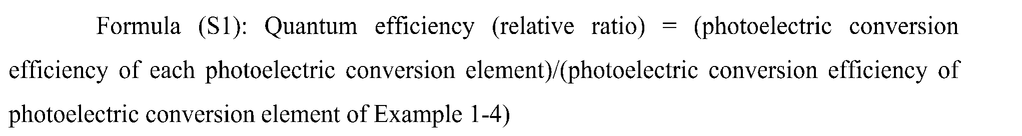 Quantum efficiency (relative ratio) = (photoelectric conversion efficiency of each photoelectric conversion element)/(photoelectric conversion efficiency of photoelectric conversion element of Example 1-4)
A: Quantum efficiency (relative ratio) was 1.4 or more.
B: Quantum efficiency (relative ratio) was 1.2 or more and less than 1.4.
C: Quantum efficiency (relative ratio) was 1.0 or more and less than 1.2.
D: Quantum efficiency (relative ratio) was 0.8 or more and less than 1.0.
E: Quantum efficiency (relative ratio) was less than 0.8.

### [Electric field strength dependence of the quantum efficiency]

The electric field strength dependence of the quantum efficiency of each photoelectric conversion element in a case of receiving blue-green light was evaluated by the following method.

The quantum efficiency (photoelectric conversion efficiency) at an electric field strength of 7.0 × 10⁴ V/cm was measured in the same procedure as the evaluation of the above-described [Quantum efficiency].

The electric field strength dependence of the quantum efficiency was calculated according to Formula (S2), and the electric field strength dependence of the quantum efficiency was evaluated according to the following evaluation standard. In Formula (S2), the numerator and the denominator are values measured for the same photoelectric conversion element of Examples or Comparative Examples. It is preferable that the electric field strength dependence of the quantum efficiency be evaluated as C or higher. 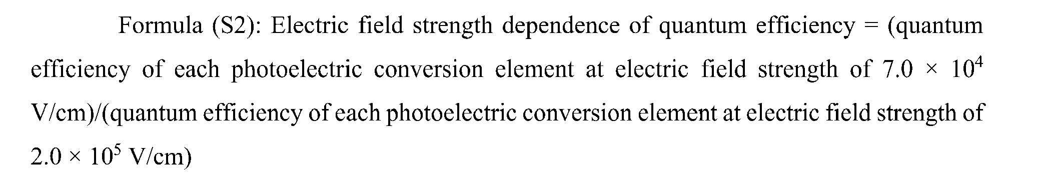 Electric field strength dependence of quantum efficiency = (quantum efficiency of each photoelectric conversion element at electric field strength of 7.0 × 104 V/cm)/(quantum efficiency of each photoelectric conversion element at electric field strength of 2.0 × 105 V/cm)
A: Electric field strength dependence of the quantum efficiency was 0.9 or more.
B: Electric field strength dependence of the quantum efficiency was 0.8 or more and less than 0.9.
C: Electric field strength dependence of the quantum efficiency was 0.7 or more and less than 0.8.
D: Electric field strength dependence of the quantum efficiency was 0.6 or more and less than 0.7.
E: Electric field strength dependence of the quantum efficiency was less than 0.6.

### [Response speed]

For each photoelectric conversion element, a response speed in a case of receiving blue-green light was evaluated by the following method.

A voltage was applied to the photoelectric conversion element with a strength of 2.0 × 10⁵ V/cm. Thereafter, a light emitting diode (LED) was turned on for an instant to emit light from the upper electrode (transparent conductive film) side, a photocurrent at this time at a wavelength of 460 nm was measured with an oscilloscope, a rise time until the signal intensity rose from 0% to 97% was measured, and the relative response speed was calculated according to Formula (S3). From the obtained values, the response speed was evaluated according to the following evaluation standard. 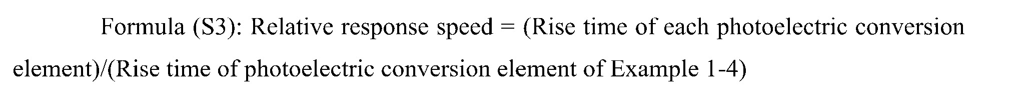 Relative response speed = (Rise time of each photoelectric conversion element)/(Rise time of photoelectric conversion element of Example 1-4)
A: Relative response speed was less than 0.5.
B: Relative response speed was 0.5 or more and less than 1.0.
C: Relative response speed was 1.0 or more and less than 2.0.
D: Relative response speed was 2.0 or more and less than 3.0.
E: Relative response speed was 3.0 or more.

### [Manufacturing suitability]

Manufacturing suitability of each photoelectric conversion element was evaluated by the following method.

A photoelectric conversion element (B) of each of Examples or each of Comparative Examples was produced by the same procedure as [Production of photoelectric conversion element] described above, except that the film formation rate of the photoelectric conversion film 12 was set to 3.0 Å/sec. For the obtained photoelectric conversion element (B), the quantum efficiency (photoelectric conversion efficiency) of the photoelectric conversion element (B) was measured by the same method as [Quantum efficiency] described above.

The photoelectric conversion element obtained in [Production of photoelectric conversion element] described above, in which the film formation rate of the photoelectric conversion film 12 was set to 1.0 Å/sec, was defined as a photoelectric conversion element (A), and a relative ratio B/A of the quantum efficiency (photoelectric conversion efficiency) was calculated according to Formula (S4). From the obtained values, the manufacturing suitability was evaluated according to the following evaluation standard. In Formula (S4), the photoelectric conversion element (B) and the photoelectric conversion element (A) in the numerator and the denominator are photoelectric conversion elements produced using the same material.

As the value of the relative ratio B/A was closer to 1, the performance of the photoelectric conversion element was less likely to deteriorate even in a case where the film formation rate was increased, that is, the manufacturing suitability was excellent. 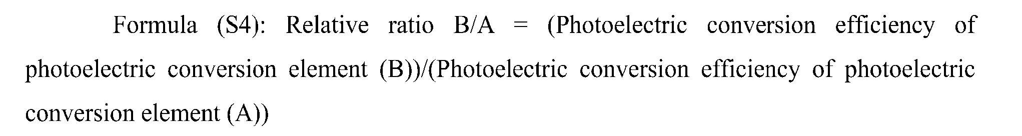 Relative ratio B/A = (Photoelectric conversion efficiency of photoelectric conversion element (B))/(Photoelectric conversion efficiency of photoelectric conversion element (A))
A: relative ratio B/A was 0.90 or more.
B: relative ratio B/A was 0.85 or more and less than 0.90.
C: relative ratio B/A was 0.80 or more and less than 0.85.
D: relative ratio B/A was 0.75 or more and less than 0.80.
E: relative ratio B/A was less than 0.75.

### [Result]

The evaluation results are shown in Table 1.

In the table, the column of "Formula (1)" was "A" in a case where the compound was a compound represented by Formula (1) and "B" in a case other than the above.

In the table, the column of "Requirement X1/X2, Requirement Y1/Y2" was "A" in a case where the specific compound satisfied at least one of the requirement X1 or the requirement X2 in a case where D represented a group represented by Formula (2), and satisfied at least one of the requirement Y1 or the requirement Y2 in a case where D represented a group represented by Formula (3), and "B" in a case other than the above.

In the table, the column of "Formula (A-1)" was "A" in a case where A¹ and A² in the specific compound were a group represented by Formula (A-1) and "B" in a case other than the above.

In the table, the column of "X²², X³²" was "A" in a case where X²² in the specific compound represented a sulfur atom, an oxygen atom, or a selenium atom, and X³² represented a sulfur atom, an oxygen atom, or a selenium atom, and "B" in a case other than the above.

In the table, the column of "X²¹, X³¹" was "A" in a case where X²¹ in the specific compound represented -NR^{X1}-, -CR^{X2}R^{X3}-, or -SiR^{X4}R^{X5}-, and X³¹ represented -NR^{X1}-, - CR^{X2}R^{x3}-, or -SiR^{X4}R^{X5}, and "B" in a case other than the above.

In the table, the column of "Y²¹ to Y²⁴, Y³¹ to Y³⁴" was "A" in a case where Y²¹ to Y²⁴ in the specific compound each independently represented -CR^{Y1}=- and Y³¹ to Y³⁴ each independently represented -CR^{Y1}=, and "B" in a case other than the above.

In the table, the description of "-" represents that the evaluation was not performed.

**[Table 1]**

| Table 1 | Compound | Formula (1) | Requirement X1/X2 | Formula (A-1) | X²², X³² | X²¹, X³¹ | Y²¹ to Y²⁴ | Quantum efficiency | Electric field strength dependence of quantum efficiency | Response speed | Manufacturing suitability |
|---|---|---|---|---|---|---|---|---|---|---|---|
| | | | Requirement Y1/Y2 | | | | Y³¹ to Y³⁴ | | | | |
| Example 1-1 | B-1 | A | A | A | A | A | A | A | A | A | A |
| Example 1-2 | B-2 | A | A | A | A | A | B | A | A | B | A |
| Example 1-3 | B-3 | A | A | A | A | A | A | A | A | A | A |
| Example 1-4 | B-4 | A | B | A | A | B | A | C | C | C | B |
| Example 1-5 | B-5 | A | A | A | A | A | A | A | A | A | A |
| Example 1-6 | B-6 | A | A | A | A | A | A | A | A | A | A |
| Example 1-7 | B-7 | A | A | B | A | A | A | B | B | C | A |
| Example 1-8 | B-8 | A | A | A | B | A | A | B | B | B | A |
| Example 1-9 | B-9 | A | A | A | A | A | A | A | A | A | A |
| Example 1-10 | B-10 | A | A | A | A | A | B | A | A | B | A |
| Example 1-11 | B-11 | A | A | A | A | A | A | A | A | A | A |
| Example 1-12 | B-12 | A | A | A | A | B | A | A | B | A | A |
| Example 1-13 | B-13 | A | A | A | A | A | A | A | A | A | A |
| Example 1-14 | B-14 | A | A | A | A | A | A | A | A | A | A |
| Example 1-15 | B-15 | A | A | B | A | A | A | B | B | C | A |
| Example 1-16 | B-16 | A | A | A | B | A | A | B | B | B | A |
| Example 1-17 | B-17 | A | A | A | B | A | A | B | B | B | A |
| Example 1-18 | B-18 | A | A | A | A | A | A | A | A | A | A |
| Example 1-19 | B-19 | A | A | A | A | A | A | A | A | A | A |
| Example 1-20 | B-20 | A | A | A | A | A | A | A | A | A | A |
| Example 1-21 | B-21 | A | A | A | A | A | A | A | A | A | A |
| Example 1-22 | B-22 | A | A | A | A | A | A | A | A | A | A |
| Example 1-23 | B-23 | A | A | A | A | A | A | A | A | A | A |
| Example 1-24 | B-24 | A | A | A | A | A | A | A | A | A | A |
| Example 1-25 | B-25 | A | A | A | A | A | A | A | A | A | A |
| Example 1-26 | B-26 | A | A | A | A | A | B | A | A | B | A |
| Example 1-27 | B-27 | A | A | A | A | A | A | A | A | A | A |
| Example 1-28 | B-28 | A | A | A | A | A | A | A | A | A | A |
| Example 1-29 | B-29 | A | A | A | A | A | A | A | A | A | A |
| Example 1-30 | B-30 | A | A | A | A | A | A | A | A | A | A |
| Example 1-31 | B-31 | A | A | A | B | A | A | B | B | B | A |
| Example 1-32 | B-32 | A | A | A | B | A | A | B | B | B | A |
| Example 1-33 | B-33 | A | A | A | B | A | A | B | B | B | A |
| Example 1-34 | B-34 | A | A | A | A | A | A | A | A | A | A |
| Example 1-35 | B-35 | A | A | A | A | A | A | A | A | A | A |
| Example 1-36 | B-36 | A | A | A | A | A | A | A | A | A | A |
| Example 1-37 | B-37 | A | A | A | A | A | A | A | A | A | A |
| Comparative Example 1-1 | C-1 | - | - | - | - | - | - | D | D | E | D |
| Comparative Example 1-2 | C-2 | - | - | - | - | - | - | E | D | E | D |
| Comparative Example 1-3 | C-3 | - | - | - | - | - | - | D | D | D | C |
| Comparative Example 1-4 | C-4 | - | - | - | - | - | - | E | D | D | C |
| Comparative Example 1-5 | C-5 | - | - | - | - | - | - | D | E | E | C |

From the results shown in Table 1, it was confirmed that the photoelectric conversion element according to the embodiment of the present invention had a small electric field strength dependence of the quantum efficiency for blue-green light. In addition, it was confirmed that the photoelectric conversion element according to the embodiment of the present invention also had excellent quantum efficiency, response speed, and manufacturing suitability for blue-green light.

From the comparison between Example 1-4 and Example 1-12, it was found that, in a case where the specific compound satisfied at least one of the requirement X1 or the requirement X2 in a case where D represented a group represented by Formula (2), and satisfied at least one of the requirement Y1 or the requirement Y2 in a case where D represented a group represented by Formula (3), it was confirmed that the quantum efficiency, the electric field strength dependence of the quantum efficiency, the response speed, and the manufacturing suitability for blue-green light were more excellent.

From the comparison between Example 1-7 and 1-15 and other examples, it was confirmed that the response speed was more excellent in a case where A¹ and A² were a group represented by Formula (A-1).

From the comparison between Example 1-8 and 1-16 and other examples, it was confirmed that the quantum efficiency was more excellent in a case where X²² in the specific compound represented a sulfur atom, an oxygen atom, or a selenium atom, and X³² represented a sulfur atom, an oxygen atom, or a selenium atom.

From the comparison between Example 1-4 and 1-12 and other examples, it was confirmed that the electric field strength dependence of the quantum efficiency was smaller in a case where X²¹ represented -NR^{X1}-, -CR^{X2}R^{X3}-, or -SiR^{X5}R^{X5}-, and X³¹ represented -NR^{X1}-, - CR^{X2}R^{x3}-, or -SiR^{X4}R^{X5}-.

From the comparison between Example 1-2, 1-10, and 1-16 and other examples, it was confirmed that the response speed was more excellent in a case where Y²¹ to Y²⁴ in the specific compound each independently represented -CR^{Y1}=, and Y³¹ to Y³⁴ each independently represented -CR^{Y1}=.

Subsequently, the photoelectric conversion element was produced using a coloring agent other than the specific compound in addition to the specific compound or the comparative compound, and the quantum efficiency, the electric field strength dependence of the quantum efficiency, the response speed, and the manufacturing suitability of the photoelectric conversion element in a case of receiving light at a wavelength of 460 nm were evaluated by the following method.

A photoelectric conversion element was produced in the same procedure as the production of the photoelectric conversion element described above, except that a photoelectric conversion film (film thickness: 320 nm) was formed by co-vapor-depositing each specific compound or each comparative compound, the n-type organic semiconductor (fullerene (C₆₀)), the p-type organic semiconductor (compound (D-1)), and any coloring agent selected from (R-1) to (R-10) by a vacuum vapor deposition method such that the specific compound: coloring agent:p-type organic semiconductor:n-type organic semiconductor was 1:1:2:2 in terms of single layer thickness.

As a result, the same results as the quantum efficiency, the electric field strength dependence of the quantum efficiency, the response speed, and the manufacturing suitability shown in Table 1 were obtained even in a case of using the coloring agent in combination. Specifically, for example, the photoelectric conversion element produced using the compound B-1 according to the above-described method exhibited the same evaluation results as Example 1-1 of Table 1. A photoelectric conversion element was produced for all combinations of the specific compound and the coloring agent, and each evaluation was performed.

### Explanation of References

10a, 10b: photoelectric conversion element
11: conductive film (lower electrode)
12: photoelectric conversion film
15: transparent conductive film (upper electrode)
16A: electron blocking film
16B: hole blocking film

## Claims

1. A photoelectric conversion element comprising, in the following order:
a conductive film;
a photoelectric conversion film; and
a transparent conductive film,
wherein the photoelectric conversion film contains a compound represented by Formula (1), 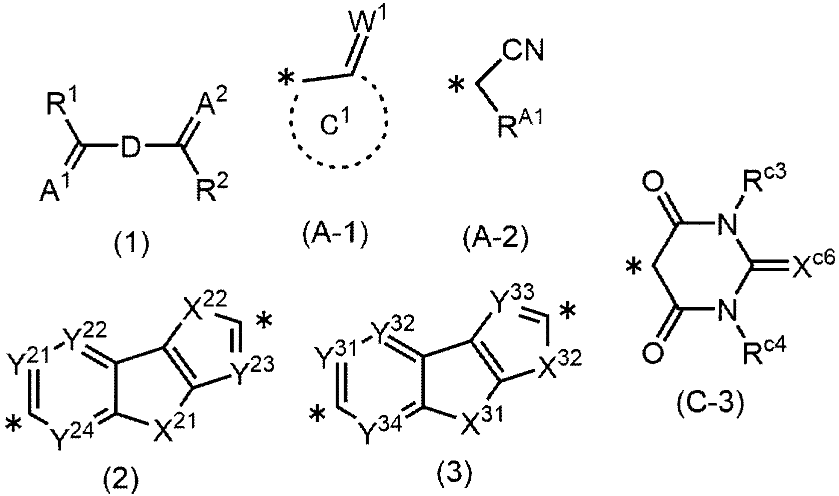
in Formula (1),
R¹ and R² each independently represent a hydrogen atom or a substituent,
A¹ and A² each independently represent a group represented by Formula (A-1) or a group represented by Formula (A-2),
D represents a group represented by Formula (2) or a group represented by Formula (3),
in Formula (2),
* represents a bonding position,
X²¹ and X²² each independently represent a sulfur atom, an oxygen atom, a selenium atom, -NR^{X1}-, -CR^{X2}R^{X3}-, or -SiR^{X4}R^{X5}-,
Y²¹ to Y²⁴ each independently represent -CR^{Y1}= or a nitrogen atom, in Formula (3),
* represents a bonding position,
X³¹ and X³² each independently represent a sulfur atom, an oxygen atom, a selenium atom, -NR^{X1}-, -CR^{X2}R^{X3}-, or -SiR^{X4}R^{X5}-
Y³¹ to Y³⁴ each independently represent -CR^{Y1}= or a nitrogen atom,
R^{X1} to R^{X5} each independently represent a hydrogen atom, an aliphatic hydrocarbon group which may have a substituent, an aromatic ring group which may have a substituent, or an aliphatic heterocyclic group which may have a substituent, R^{X2} and R^{X3} may be linked to each other to form a ring, and R^{X4} and R^{X5} may be linked to each other to form a ring,
R^{Y1}'s each independently represent a hydrogen atom or a substituent,
in Formula (A-1),
* represents a bonding position,
C¹ represents a ring which contains 2 or more carbon atoms and may have a substituent,
W¹ represents a sulfur atom, an oxygen atom, =NR^{W2}, or =CR^{W3}R^{W4}
R^{W2} represents a hydrogen atom or a substituent, R ^{W3} and R^{W4} each independently represent a cyano group, -SO₂R^{W5}, -COOR^{W6}, or -COR^{W7}
R^{W5} to R^{W7} each independently represent an aliphatic hydrocarbon group which may have a substituent, an aromatic ring group which may have a substituent, or an aliphatic heterocyclic group which may have a substituent,
in Formula (A-2),
* represents a bonding position,
R^{A1} represents a cyano group or -COR^{A2}, R^{A2} represents an aromatic ring group which may have a substituent or an aliphatic hydrocarbon group which may have a substituent,
in a case where D represents a group represented by Formula (2), X²¹ is - CR^{X2}R^{X3}-, X²² is a sulfur atom, and Y²¹ to Y²⁴ are all -CH=, A¹ and A² each independently represent a group represented by Formula (C-3), and
in Formula (C-3),
X^{c6} represents an oxygen atom or a sulfur atom,
R^{c3} and R^{c4} each independently represent an aliphatic hydrocarbon group which may have a substituent.

2. The photoelectric conversion element according to claim 1,
wherein, in a case where D represents a group represented by Formula (2), at least one of a requirement X1 or a requirement X2 is satisfied, and
in a case where D represents a group represented by Formula (3), at least one of a requirement Y1 or a requirement Y2 is satisfied,
Requirement X1: at least one of X²¹ or X²² represents -NRs-, -CRsR^{X3}-, or -SiRsR^{X5}-,
Requirement X2: at least one of Y²¹ to Y²⁴ represents -CRt=,
Requirement Y1: at least one of X³¹ or X³² represents -NRs-, -CRsR^{X3}-, or -SiRsR^{X5}-,
Requirement Y2: at least one of Y³¹ to Y³⁴ represents -CRt=,
Rs represents an aliphatic hydrocarbon group which may have a substituent, an aromatic ring group which may have a substituent, or an aliphatic heterocyclic group which may have a substituent,
Rs and R^{X3} may be linked to each other to form a ring, and Rs and R^{X5} may be linked to each other to form a ring, and
Rt represents a substituent.

3. The photoelectric conversion element according to claim 1,
wherein A¹ and A² each independently represent a group represented by Formula (A-1).

4. The photoelectric conversion element according to claim 2,
wherein X²² represents a sulfur atom, an oxygen atom, or a selenium atom, and X³² represents a sulfur atom, an oxygen atom, or a selenium atom.

5. The photoelectric conversion element according to claim 2,
wherein X²¹ represents -NR^{X1}-, -CR^{X2}R^{X3}-, or -SiR^{X4}R^{X5}-, and X³¹ represents -NR^{X1}-, -CR^{X2}R^{X3P}-, or -SiR^{X4}R^{x5}.

6. The photoelectric conversion element according to any one of claims 1 to 5,
wherein Y²¹ to Y²⁴ each independently represent -CR^{Y1}=, and Y³¹ to Y³⁴ each independently represent -CR^{Y1}=.

7. The photoelectric conversion element according to any one of claims 1 to 5,
wherein the photoelectric conversion film further contains an n-type organic semiconductor, and
the photoelectric conversion film has a bulk heterojunction structure formed in a state in which the compound represented by Formula (1) and the n-type organic semiconductor are mixed with each other.

8. The photoelectric conversion element according to claim 7,
wherein the n-type organic semiconductor contains fullerenes selected from the group consisting of a fullerene and derivatives of the fullerene.

9. The photoelectric conversion element according to any one of claims 1 to 5,
wherein the photoelectric conversion film further contains a p-type organic semiconductor.

10. The photoelectric conversion element according to any one of claims 1 to 5,
wherein the photoelectric conversion film further contains a coloring agent.

11. The photoelectric conversion element according to any one of claims 1 to 5, further comprising:
one or more interlayers between the conductive film and the transparent conductive film, in addition to the photoelectric conversion film.

12. An imaging element comprising:
the photoelectric conversion element according to any one of claims 1 to 5.

13. An optical sensor comprising:
the photoelectric conversion element according to any one of claims 1 to 5.

14. A method for manufacturing an imaging element, comprising:
a step of manufacturing the photoelectric conversion element according to any one of claims 1 to 5.

15. A compound represented by Formula (1), 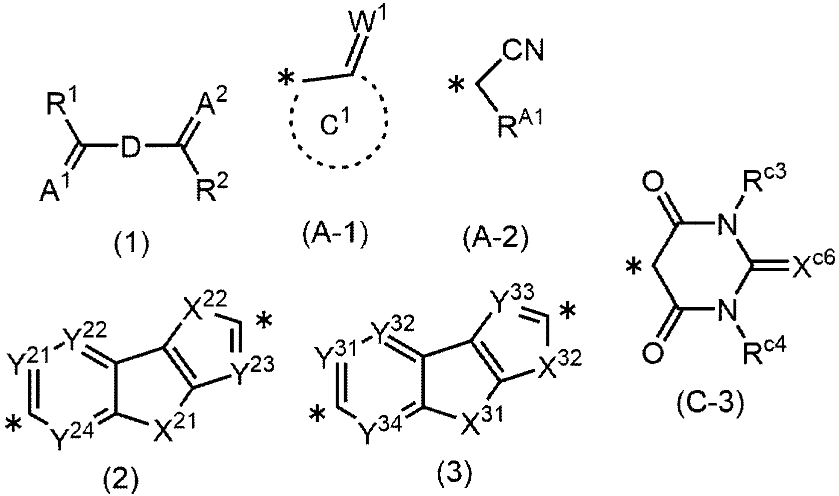
in Formula (1),
R¹ and R² each independently represent a hydrogen atom or a substituent,
A¹ and A² each independently represent a group represented by Formula (A-1) or a group represented by Formula (A-2),
D represents a group represented by Formula (2) or a group represented by Formula (3).
in Formula (2),
* represents a bonding position,
X²¹ and X²² each independently represent a sulfur atom, an oxygen atom, a selenium atom, -NR^{X1}-, -CR^{X2}R^{X3}-, or -SiR^{X4}R^{X5}-,
Y²¹ to Y²⁴ each independently represent -CR^{Y1}= or a nitrogen atom,
in Formula (3),
* represents a bonding position,
X³¹ and X³² each independently represent a sulfur atom, an oxygen atom, a selenium atom, -NR^{X1}-, -CR^{X2}R^{X3}-, or -SiR^{X4}R^{X5}-,
Y³¹ to Y³⁴ each independently represent -CR^{Y1}= or a nitrogen atom,
R^{X1} to R^{X5} each independently represent a hydrogen atom, an aliphatic hydrocarbon group which may have a substituent, an aromatic ring group which may have a substituent, or an aliphatic heterocyclic group which may have a substituent, R^{X2} and R^{X3} may be linked to each other to form a ring, and R^{X4} and R^{X5} may be linked to each other to form a ring,
R^{Y1}'s each independently represent a hydrogen atom or a substituent,
in Formula (A-1),
* represents a bonding position,
C¹ represents a ring which contains 2 or more carbon atoms and may have a substituent,
W¹ represents an oxygen atom, a sulfur atom, =NR^{W2}, or =CR^{W3}R^{W4},
R^{W2} represents a hydrogen atom or a substituent, R^{W3} and R^{W4} each independently represent a cyano group, -SO₂R^{W5}, -COOR^{W6}, or -COR^{W7}, and
R^{W5} to R^{W7} each independently represent an aliphatic hydrocarbon group which may have a substituent, an aromatic ring group which may have a substituent, or an aliphatic heterocyclic group which may have a substituent,
in Formula (A-2),
* represents a bonding position.
R^{A1} represents a cyano group or -COR^{A2}, R^{A2} represents an aromatic ring group which may have a substituent or an aliphatic hydrocarbon group which may have a substituent,
in a case where D represents a group represented by Formula (2), X²¹ is - CR^{X2}R^{x3}-, X²² is a sulfur atom, and Y²¹ to Y²⁴ are all -CH=, A¹ and A² each independently represent a group represented by Formula (C-3), and
in Formula (C-3),
X^{c6} represents an oxygen atom or a sulfur atom,
C^{c3} and R^{c4} each independently represent an aliphatic hydrocarbon group which may have a substituent.

16. The compound according to claim 15,
wherein, in a case where D represents a group represented by Formula (2), at least one of a requirement X1 or a requirement X2 is satisfied, and
in a case where D represents a group represented by Formula (3), at least one of a requirement Y1 or a requirement Y2 is satisfied,
Requirement X1: at least one of X²¹ or X²² represents -NRs-, -CRsR^{x3}-, or -SiRsR^{x5}-,
Requirement X2: at least one of Y²¹ to Y²⁴ represents -CRt=,
Requirement Y1: at least one of X³¹ or X³² represents -NRs-, -CRsR^{x3}-, or -SiRsR^{X5}-,
Requirement Y2: at least one of Y³¹ to Y³⁴ represents -CRt=,
Rs represents an aliphatic hydrocarbon group which may have a substituent, an aromatic ring group which may have a substituent, or an aliphatic heterocyclic group which may have a substituent,
Rs and R^{X3} may be linked to each other to form a ring, and Rs and R^{X5} may be linked to each other to form a ring, and
Rt represents a substituent.

17. The compound according to claim 15,
wherein A¹ and A² each independently represent a group represented by Formula (A-1).

18. The compound according to claim 16,
wherein X²² represents a sulfur atom, an oxygen atom, or a selenium atom, and X³² represents a sulfur atom, an oxygen atom, or a selenium atom.

19. The compound according to claim 16,
wherein X²¹ represents -NR^{X1}-, -CR^{X2}R^{X3}-, or -SiR^{X4}R^{X5}-,and X³¹ represents -NR^{X1}-, -CR^{X2}R^{X3}-, or -SiR^{X4}R^{X5}-.

20. The compound according to any one of claims 15 to 19,
wherein Y²¹ to Y²⁴ each independently represent -CR^{Y1}=, and Y³¹ to Y³⁴ each independently represent -CR^{Y1}=.
